# FASCICULE DE BREVET EUROPEEN

(11) **EP 3 814 808 B1**
(45) Date de publication et mention de la délivrance du brevet: **02.09.2026**
(21) Numéro de dépôt: 19733505.2
(22) Date de dépôt: 28.06.2019
(51) Int. Cl.: G01V 3/08, G01R 33/28, G01V 3/10, G01V 3/165

(54) **SYSTÈME DE DÉTECTION PORTABLE COMPRENANT DES CAPTEURS MAGNÉTOSTATIQUES**
TRAGBARES DETEKTIONSSYSTEM MIT MAGNETOSTATISCHEN SENSOREN
PORTABLE DETECTION SYSTEM COMPRISING MAGNETOSTATIC SENSORS

(30) Priorité: 28.06.2018 FR 1855903
(43) Date de publication de la demande: 05.05.2021
(73) Titulaire: Manneschi, Alessandro, 52100 Arezzo (IT)
(72) Inventeur: Manneschi, Alessandro, 52100 Arezzo (IT)
(74) Mandataire: Regimbeau
(86) Numéro de dépôt international: PCT/EP2019/067475
(87) Numéro de publication internationale: WO 2020/002680

(56) Documents cités:
- EP-A1- 1 247 119
- EP-A1- 1 247 119
- EP-B1- 1 247 119
- US-A1- 2006 197 523
- US-A1- 2006 197 523
- US-A1- 2017 176 623
- US-A1- 2017 176 623
- US-A1- 2018 012 465
- US-A1- 2018 012 465

## Description

### DOMAINE DE L'INVENTION

L'invention concerne le domaine de la détection d'objets cibles, et plus particulièrement de la détection d'objets comprenant des éléments magnétisés ou ferromagnétiques.

### ARRIERE-PLAN TECHNOLOGIQUE

Le climat actuel résultant de diverses attaques dans des lieux publics a fait naître le besoin de détecter des armes du type fusil d'assaut à l'entrée des lieux publics, tels que des stades, des salles de concert, des grands magasins, etc.

Actuellement, cette détection est généralement assurée par un personnel de sécurité, équipé de détecteurs portables manuels déplacés le long du corps et autour des affaires des personnes souhaitant entrer dans les différents lieux publics concernés. Toutefois, une telle inspection est longue est fastidieuse, et la quantité de personnes souhaitant entrer dans le lieu concerné est souvent trop importante pour qu'elle soit effectuée de manière satisfaisante.

Il a également été proposé d'installer des portiques à demeure à l'entrée des différents lieux publics. Ces portiques sont bien adaptés dans le cas où une installation fixe est nécessaire. Toutefois, une telle installation nécessite la réalisation de travaux importants, ce qui la rend peu adaptée pour les lieux publics du type stades, salles de concert et grands magasins. De plus, les portiques ne peuvent pas être déplacés. Or, dans les lieux publics, il est nécessaire de pouvoir libérer l'espace pour permettre une sortie éventuelle urgente sans obstacle, ce qui rend souhaitable l'utilisation de systèmes portatifs.

Il a donc été proposé d'utiliser des barrières individuelles portables comprenant des capteurs magnétostatiques. De telles barrières comprennent généralement un poteau fixé sur un socle et équipé d'au moins un capteur magnétostatique, par exemple trois capteurs magnétostatiques répartis sur la hauteur du poteau. Chaque capteur est configuré pour générer un signal (tension) indicatif d'une intensité d'un champ électromagnétique détecté. Ces barrières sont notamment utilisées dans des prisons afin de détecter si les prisonniers portent des objets magnétiques, et plus particulièrement des téléphones portables. Pour cela, la sensibilité des capteurs magnétiques peut être très élevées, les prisonniers étant normalement privés de tout matériau métallique ou magnétique.

Afin d'augmenter la sensibilité de ces barrières, il a également été proposé de les utiliser par paire de sorte à former une porte. En effet, la sensibilité des capteurs décroît exponentiellement avec la distance. De telles barrières présentent l'avantage d'être portables et de ne pas nécessiter de travaux pour leur mise en place. De plus, les fusils d'assaut actuels étant réalisés dans un métal ferromagnétique et étant de grande taille, la perturbation du champ électromagnétique terrestre qu'ils engendrent est suffisamment importante pour être détectée par ces capteurs.

Toutefois, contrairement aux prisons, les personnes portent souvent sur elles des objets métalliques pouvant comprendre des éléments magnétisés ou ferromagnétiques, et dans la plupart des cas des téléphones intelligents (smartphones) dont les puces sont magnétisées. Or, le champ magnétique autonome des smartphones est sensiblement comparable à la perturbation du champ électromagnétique terrestre engendrée par le passage d'un fusil d'assaut. Le passage de ces personnes déclenche donc systématiquement l'alarme des barrières, même en l'absence de fusils d'assaut. Il est donc nécessaire de pouvoir discriminer les smartphones des fusils d'assaut afin de garantir la capacité des barrières à détecter ces armes.

Il a donc été proposé dans le document WO 2017/141022 d'ajouter un espaceur à chacune des barrières, afin de guider la personne inspectée et à la faire passer au milieu de la porte formée par les barrières, où la sensibilité de la porte formée par une paire de barrières est plus uniforme. En effet, la sensibilité des capteurs magnétostatiques étant inversement proportionnelle à la distance, les capteurs sont plus sensibles à proximité des barrières qu'au centre. Or, cet excès de sensibilité à proximité des barrières cause un taux d'alarmes intempestif presque total. La présence des espaceurs permet donc d'éviter que les personnes à inspecter s'approchent trop près des barrières et restent au centre de la porte, où la sensibilité est plus faible et serait plus uniforme.

Toutefois, une telle augmentation de la distance entre les barrières risque de rendre la porte sensible aux interférence environnementales dans la mesure où le signal à cette distance des barrières est plus faible et s'approche donc des signaux générés par les éléments alentours. De plus, les barrières ainsi obtenues sont plus difficiles à transporter, car beaucoup plus lourdes et encombrantes que les barrières initiales. Enfin, dans le cas où des portes multiples doivent être créer, notamment à l'abord de stades ou de grandes salles de concert, l'ensemble former par chaque paire de barrières est très encombrant et limite ainsi le nombre de portes pouvant être créées.

Le document US 2018/012465 décrit un système de détection conforme au préambule de la revendication 1. En particulier, ce document décrit un système de détection comprenant des détecteurs comportant chacun au moins un capteur magnétique configuré pour générer un signal indicatif d'une intensité d'un champ magnétique détecté et, pour chaque détecteur, une unité de traitement configurée pour recevoir les signaux indicatifs d'une intensité d'un champ magnétique détecté par les capteurs. Dans la mesure où le champ magnétique produit au niveau d'un détecteur est inversement proportionnel au cube de la distance de sensibilité r d'un détecteur, les deux détecteurs du système de ce document sont écartés d'une longueur égale à la moitié de leur distance de sensibilité. De la sorte, les détecteurs sont indépendants et leurs sensibilités peuvent être diminuées.

Le document US 2006/197523 décrit un système de détection d'un objet comprenant plusieurs détecteurs comprenant chacun plusieurs gradiomètres et un processeur configuré pour collecter les signaux générés par les gradiomètres. Le processeur calcule une valeur moyenne des signaux collectés afin d'obtenir une mesure du bruit de fond. Cette moyenne est ensuite soustraite aux signaux générés par les gradiomètres afin d'éliminer le bruit.

### RESUME DE L'INVENTION

Un objectif de l'invention est donc de proposer un système de détection pouvant être installé et désinstallé rapidement, par exemple à l'entrée de lieux publics, qui soit de faible encombrement et qui, le cas échéant, soit en outre capable de discriminer de manière fiable des petits objets comprenant des éléments magnétiques, tels que des smartphones, et de détecter des fusils d'assaut.

Pour cela, l'invention propose un système selon la revendication 1.

Certaines caractéristiques préférées mais non limitatives du système de détection décrit ci-dessus sont définies dans les revendications 2 à 4

Selon un deuxième aspect, l'invention propose également un ^procédé selon la revendication 5.

Certaines caractéristiques préférées mais non limitatives du procédé de détection décrit ci-dessus sont définies dans les revendications 6 à 15.

### BREVE DESCRIPTION DES DESSINS

D'autres caractéristiques, buts et avantages de la présente invention apparaîtront mieux à la lecture de la description détaillée qui va suivre, et au regard des dessins annexés donnés à titre d'exemples non limitatifs et sur lesquels :
La figure 1 est une illustration synoptique d'un exemple de détecteur pouvant être utilisé dans un système de détection conforme à l'invention.
La figure 2 illustre un exemple de réalisation d'un système de détection conforme à l'invention comprenant deux détecteurs.
La figure 3 illustre un exemple de réalisation d'un système de détection conforme à l'invention comprenant trois détecteurs formant ensemble deux portes, une personne étant en cours d'inspection au sein de l'une des portes.

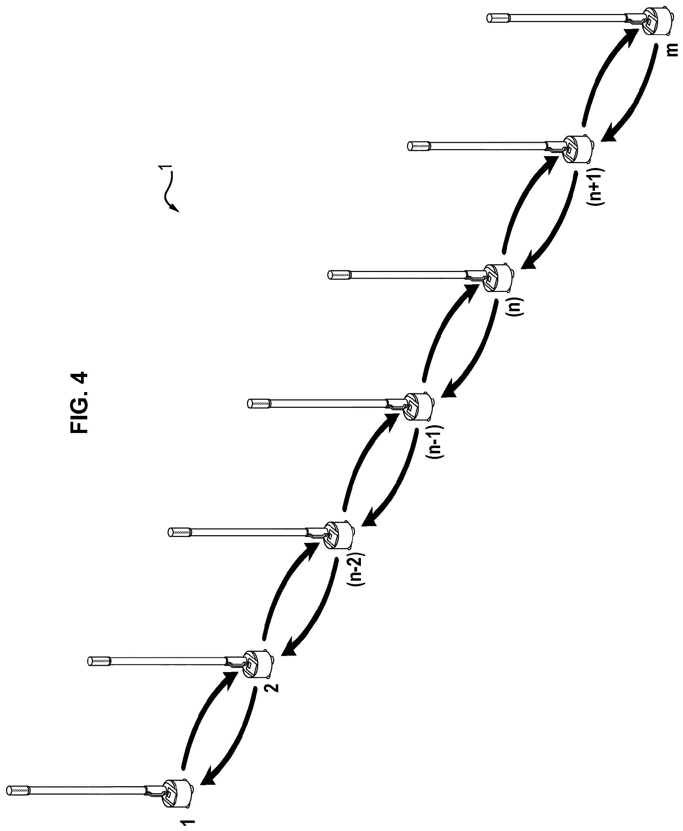

La figure 4 illustre un exemple de réalisation d'un système de détection conforme à l'invention comprenant *m* détecteurs formant ensemble *m -* 1 portes.

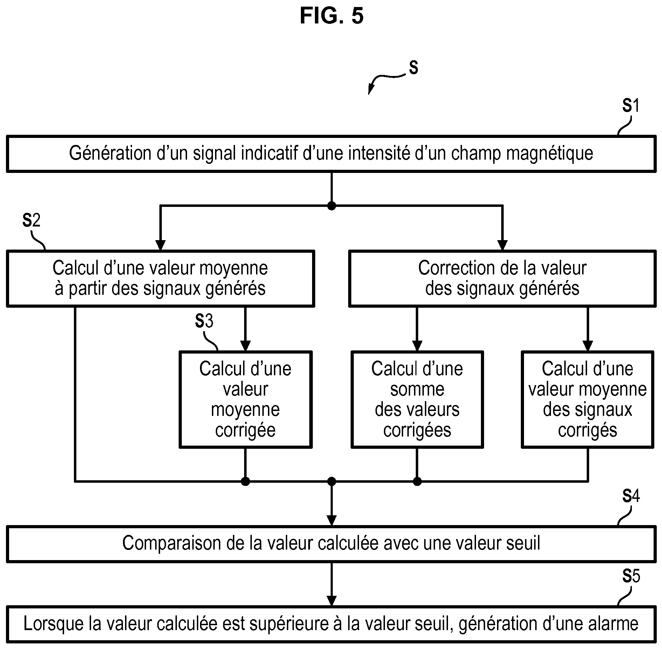

La figure 5 est un organigramme illustrant les étapes générales d'un exemple de procédé de détection conforme à l'invention.
La figure 6 est un organigramme illustrant les sous-étapes de correction de la valeur de signaux.
La figure 7 est un organigramme illustrant les étapes d'un exemple de procédé de détection conforme à l'invention dans le cas où le système de détection comprend au moins quatre détecteurs (*n* - 2, *n - 1, n* et *n + 1*)*.*
La figure 8a illustre l'intensité du signal d'un système de détection conforme à l'art antérieur et comprenant deux détecteurs séparés d'une distance de 130 cm.
La figure 8b illustre l'intensité du signal d'un système de détection conforme à un mode de réalisation de l'invention comprenant deux détecteurs séparés d'une distance de 130 cm et comprenant une unité de traitement configurée pour calculer une valeur moyenne des signaux générés par les capteurs des deux détecteurs.
La figure 8c illustre l'intensité du signal d'un système de détection 1 conforme à un mode de réalisation de l'invention comprenant deux détecteurs séparés d'une distance de 130 cm et comprenant une unité de traitement configurée pour calculer une valeur moyenne corrigée des signaux générés par les capteurs des deux détecteurs.

### DESCRIPTION DETAILLEE D'UN MODE DE REALISATION

Un système de détection 1 d'un objet cible, et notamment d'un objet comprenant un matériau ferromagnétique de grande volume tel qu'un fusil d'assaut, ledit système comprenant :
- au moins un premier et un deuxième détecteur 10, 20 formant ensemble une porte,
- au moins une unité de traitement 6 et
- au moins une interface de communication 7.

Chaque détecteur 10, 20 comprend au moins un capteur magnétique 5. Par capteur magnétique (ou magnétostatique) on comprendra ici un capteur passif configuré pour détecteur un champ magnétique qui entoure naturellement des objets comprenant du fer ou tout autre élément ferromagnétique, par opposition par exemple à un bobinage inductif.

Plus précisément, le premier détecteur 10 comprend au moins un premier capteur magnétique 5, de préférence au moins deux, par exemple trois premiers capteurs magnétiques 5, tandis que le deuxième détecteur 20 comprend au moins un deuxième capteur magnétique 5. De préférence le deuxième détecteur 20 et le premier détecteur 10 comprennent chacun autant de capteurs 5.

Chaque capteur magnétique 5 est configuré pour détecter un champ magnétique et générer un signal indicatif d'une intensité du champ magnétique ainsi détecté. Dans une forme de réalisation, le signal est une tension dont la valeur est proportionnelle à l'intensité du champ magnétique détecté.

Dans une forme de réalisation, chaque capteur magnétique 5 est configuré pour détecter une intensité d'un champ magnétique suivant trois axes orthogonaux.

Chaque détecteur 10, 20 comporte en outre un poteau 3, configuré pour être posé sur un sol par exemple via un socle 4. De préférence, une hauteur du poteau 3 est sensiblement égale à une hauteur moyenne d'une personne 2, par exemple de l'ordre de 1,70 m à 2.0 m.

L'ensemble formé par le poteau 3 et son socle 4 est portable, c'est-à-dire qu'il n'est pas ancré définitivement dans le sol et peut être transporté par un opérateur. Le cas échéant, chaque détecteur 10, 20 peut être équipé par une poignée afin d'en faciliter le transport. La poignée peut notamment être fixée sur le socle 4.

Les capteurs magnétiques 5 sont répartis sur la hauteur du poteau 3 afin d'assurer une détection d'objets cibles entre les pieds et la tête des personnes 2 inspectées. Par exemple, chaque poteau 3 peut être équipé de trois capteurs magnétiques 5, répartis entre le socle 4 et l'extrémité libre du poteau 3.

Enfin, au sein d'un même système de détection 1, les capteurs magnétiques des détecteurs 10, 20 sont positionnés deux à deux à une même hauteur de sorte à former des couples de capteurs 5 en regard.

Le système 1 comprend en outre au moins une unité de traitement 6 configurée pour recevoir les signaux indicatifs d'une intensité d'un champ magnétique générés par le premier capteur magnétique 5 et/ou le deuxième capteur magnétique 5. Plus précisément, et comme nous le verrons dans ce qui suit, le système 1 peut comprendre soit une unité de traitement 6 configurée pour recevoir les signaux indicatifs d'une intensité d'un champ magnétique détecté par le premier capteur magnétique 5 et/ou le deuxième capteur magnétique 5, soit une unité de traitement 6 configurée pour recevoir les signaux indicatifs d'une intensité d'un champ magnétique détecté par le premier capteur magnétique 5 et une unité de traitement 6 configurée pour recevoir les signaux indicatifs d'une intensité d'un champ magnétique détecté par le deuxième capteur magnétique 6.

L'interface de communication 7 est configurée pour transmettre le signal généré par le deuxième capteur magnétique 5 à l'unité de traitement 6 recevant les signaux indicatifs d'une intensité d'un champ magnétique détecté par le premier capteur magnétique 5. Cette unité de traitement 6 est alors configurée pour déterminer une valeur calculée à partir des signaux indicatifs d'une intensité d'un champ magnétique détecté par le premier capteur magnétique 5 et le deuxième capteur magnétique 5. Cette valeur calculée peut notamment comprendre une valeur moyenne et/ou une valeur corrigée des signaux générés par les capteurs magnétiques 5 des premier et deuxième détecteurs 10, 20. Et lorsque ladite valeur calculée est supérieure à une valeur seuil prédéterminée, cette unité de traitement 6 est configurée pour envoyer des instructions d'émission d'une alarme.

Dans une forme de réalisation, l'unité de traitement 6 détermine une valeur moyenne arithmétique des signaux, qui correspond à la somme des valeurs des signaux divisée par le nombre de signaux.

En variante, l'unité de traitement 6 détermine une valeur moyenne géométrique des signaux, qui correspond à la racine carrée du produit des signaux.

Dans une autre variante encore, l'unité de traitement 6 détermine une valeur corrigée des signaux générés par chacun des capteurs magnétiques 5 par application d'un coefficient d'atténuation auxdits signaux.

Dans une forme de réalisation, la ou les unités de traitement 6 peuvent être intégrée(s) dans l'un parmi le premier détecteur 10 et le deuxième détecteur 20. De préférence, chaque détecteur 10, 20 comprend une unité de traitement 6 intégrée. Par intégrée, on comprendra que l'unité de traitement 6 fait partie du détecteur 10, 20 et n'est pas un élément distinct auquel est connecté le système 1.

Dans cette forme de réalisation, l'unité de traitement 6 peut par exemple être fixée sur le poteau 3 du détecteur associé, ou en variante dans son socle 4.

Dans une variante de cette forme de réalisation, l'unité de traitement 6 peut être placée à distance du premier et du deuxième détecteur 10, 20. Les détecteurs 10, 20 lui communiquent alors les signaux générés par leurs capteurs magnétiques 5 en vue de leur traitement par l'intermédiaire de leur interface de communication 7.

Dans un mode de réalisation, l'unité de traitement 6 peut comprendre :
- un convertisseur analogique numérique A/D, configuré pour convertir un signal analogique (tension) généré par un capteur magnétique 5 en signal numérique
- un processeur de signal numérique DSP (acronyme anglais de Digital Signal Processor), configuré pour élaborer le signal numérique ainsi converti et
- un système de gestion sur microcontrôleur SMM (acronyme anglais de System Management Microcomputer), configuré pour recevoir le signal numérique élaboré par le DSP et le comparer à la valeur seuil prédéterminée.

Le SMM est connecté à au moins un émetteur 8 configuré pour générer un signal d'alarme, par exemple un émetteur 8 acoustique configuré pour générer un signal acoustique et/ou une lumière configurée pour générer un signal optique (DEL, lampe clignotante, etc.). L'émetteur 8 peut être compris dans le détecteur 10, 20, ou en variante être porté par un opérateur (oreillette, etc.) auquel cas l'unité de traitement 6 envoie les instructions de génération d'une alarme à l'émetteur 8 distant par l'intermédiaire de l'interface de communication 7 du détecteur 10, 20 correspondant.

Le SMM est par ailleurs connecté à une interface asynchrone UART afin de permettre une connexion de l'unité de traitement 6 à un ordinateur (ou équivalent) pour autoriser différentes actions dont un contrôle du programme de détection, un diagnostic d'un ou de plusieurs détecteurs, le chargement de mises à jour, etc.

Enfin, le SMM est connecté à une interface homme machine HMI (acronyme anglais de Human Machine Interface).

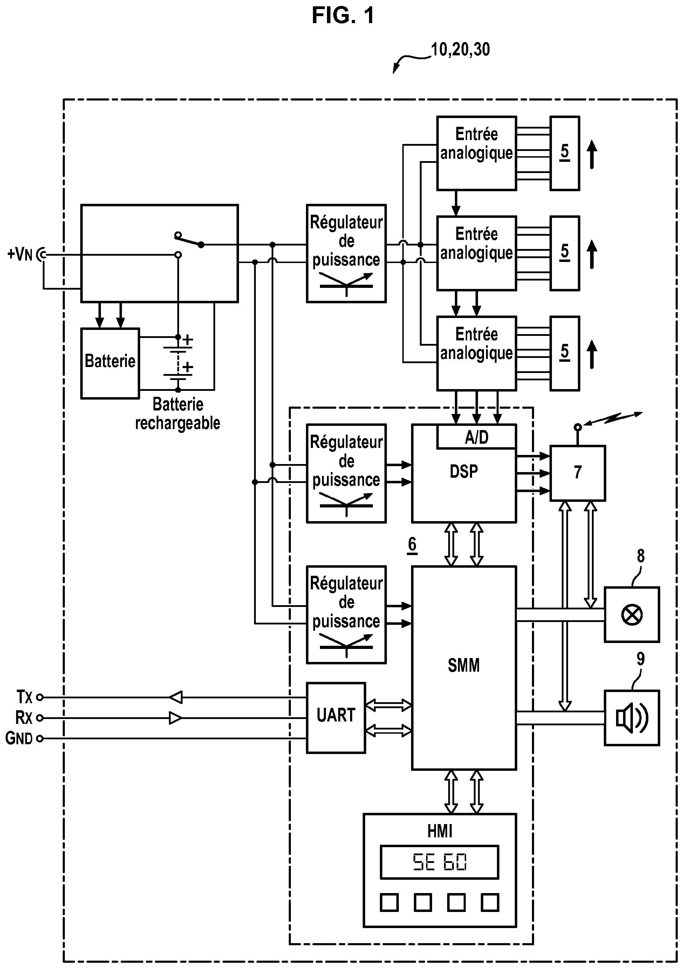

Chaque détecteur 10, 20 du système de détection 1 comprend en outre une interface de communication 7 configurée pour permettre à l'un des détecteurs 10, 20 du système 1 de communiquer avec un autre des détecteurs 20, 10 du système 1 et lui transmettre le signal généré par son ou ses capteurs magnétiques 5. Pour chaque détecteur 10, 20, l'interface de communication 7 peut être connectée soit au DSP (comme illustré sur la figure 1) de l'unité de traitement 6 de ce détecteur 10, 20, soit à son SMM et à ses émetteurs 8 d'alarme.

L'interface de communication 7 comprend de préférence une interface sans fil afin de faciliter l'installation du système de détection 1, par exemple une interface du type Wi-Fi, Bluetooth, par communication optique, radio, infrarouge ou encore inductive, etc. En variante, l'interface de communication 7 peut être filaire.

Le cas échéant, le système de détection 1 peut comprendre un plus grand nombre de détecteurs afin de former un ensemble de portes, chaque porte étant formée par deux détecteurs adjacents. De préférence, les détecteurs d'un même système de détection 1 sont sensiblement identiques deux à deux.

Par exemple, le système de détection 1 peut comporter un troisième détecteur 30 comprenant au moins un troisième capteur magnétique 5 configuré pour détecter un champ magnétique et générer un signal indicatif d'une intensité du champ magnétique ainsi détecté.

De manière analogue au premier et au deuxième détecteur 10, 20, le troisième détecteur 30 peut comporter un poteau 3 fixé sur un socle 4 et équipé du ou des troisièmes capteurs magnétiques 5 ainsi qu'une une interface de communication 7 et le cas échéant une unité de traitement 6.

Afin de former plusieurs portes, l'invention propose de placer côte à côte le premier détecteur 10, le deuxième détecteur 20 et le troisième détecteur 30 de sorte à former deux portes. Plus précisément, la première porte est formée par le premier détecteur 10 et le deuxième détecteur 20, tandis que la deuxième porte est formée par le deuxième détecteur 20 et le troisième détecteur 30. Dans le système, un même détecteur (ici, le deuxième détecteur 20) est donc utilisé pour la formation de deux portes distinctes, ce qui permet de réduire de manière conséquente l'encombrement du système de détection 1 en comparaison par exemple au système proposé dans le document WO 2017/141022. Le système est en outre plus facile à mettre en place.

Comme nous le verrons par la suite, une telle configuration est permise par le fait que l'unité de traitement 6 du deuxième détecteur 20, qui est située entre le premier détecteur 10 et le deuxième détecteur 20, peut être configurée à la fois pour traiter les signaux générés par le ou les capteurs magnétiques 5 du troisième détecteur 30 et pour communiquer avec le premier détecteur 10, de sorte que le système de détection 1 est capable de déterminer la porte au sein de laquelle un objet cible a été détecté, et ce malgré le fait que les capteur magnétiques 5 effectuent une détection scalaire et non vectorielle.

Plus précisément, l'unité de traitement 6 du deuxième détecteur 20 est configurée pour :
(i) calculer une valeur moyenne (éventuellement corrigée) ou une valeur corrigée des signaux générés par les deuxièmes et troisièmes capteurs magnétiques 5 et,
(ii) lorsque ladite valeur calculée est supérieure à la valeur seuil prédéterminée, transmettre à l'unité de traitement 6 du premier détecteur 10 via l'interface de communication 7 un signal indicatif d'une intensité d'un champ magnétique détecté par le(s) deuxième(s) capteur(s) magnétique(s) 5 ainsi que la valeur calculée.

Bien entendu, un opérateur peut également utiliser quatre détecteurs conformes à l'invention afin de former deux portes, la mutualisation du deuxième détecteur 20 n'étant pas obligatoire pour la détection d'objets cibles.

Chaque détecteur 10, 20 peut en outre comporter des moyens d'identification et une mémoire afin de permettre l'association et la communication avec les autres détecteurs du système de détection 1 ainsi que la mise en œuvre du procédé de détection S. Par exemple, à chaque détecteur 10, 20, 30 peut être assignée une adresse, qui peut être fixée au moment de la fabrication du détecteur 10, 20, 30 ou programmée au moment de l'appariement des détecteurs 10, 20, 30 formant le système de détection 1. Dans un mode de réalisation, l'adresse de chaque détecteur 10, 20, 30 est figée, c'est-à-dire non modifiable, afin de limiter les erreurs de manipulation du système de détection 1 et de faciliter le service après-vente.

Un exemple d'adresse peut comprendre une chaîne de caractères qui peut notamment être formée d'un nombre donné de couples hexadécimaux, par exemple huit.

Lors de l'appariement des détecteurs, 10, 20, 30 du système de détection 1, l'adresse des détecteurs avec lesquels un détecteur donné forme une porte est enregistrée dans la mémoire dudit détecteur donné. Par exemple, dans le cas d'un système de détection 1 comprenant le premier 10, le deuxième 20 et le troisième détecteur 30, au moment du paramétrage du système de détection 1 :
- l'adresse du deuxième détecteur 20 est enregistrée dans la mémoire du troisième détecteur 30
- l'adresse des premier et troisième détecteurs 30 est enregistrée dans la mémoire du deuxième détecteur 20 au moment du paramétrage du système de détection 1 et
- l'adresse du deuxième détecteur 20 est enregistrée dans la mémoire du premier détecteur 10.

Un exemple de procédé de détection S à l'aide d'un système de détection 1 conforme à l'invention et comprenant deux détecteurs 10, 20 va à présent être décrit.

Afin de faciliter la lecture de la description, le système de détection 1 comprend un premier détecteur 10 et un deuxième détecteur 20 comportant deux premiers capteurs magnétiques 5 et deux deuxièmes capteurs magnétiques 5, respectivement. Les premiers et deuxième capteurs magnétiques 5 forment deux couples de capteurs magnétiques 5, chaque couple comprenant un premier capteur 5 et un deuxième capteur 5. De préférence, un couple comprend un premier capteur magnétique 5 et un deuxième capteur magnétique 5 placés à proximité d'une extrémité libre du poteau 3 du premier détecteur 10 et du deuxième détecteur 20, tandis que l'autre couple comprend un premier capteur magnétique 5 et un deuxième capteur magnétique 5 placés à proximité de leur socle 4.

Les deux détecteurs sont identiques et comprennent chacun une unité de traitement 6 et une interface de communication 7.

Bien entendu, l'invention s'applique mutatis mutandis dans le cas où les détecteurs comprennent un nombre différent de capteur magnétiques 5. En particulier, les détecteurs pourraient ne comprendre qu'un seul capteur magnétique 5, ou plus de deux capteurs magnétiques 5 (par exemple trois capteurs magnétiques 5). De plus, le deuxième détecteur 20 pourrait ne pas comprendre d'unité de traitement 6, ou en variante l'unité de traitement 6 pourrait être placée à distance des détecteurs au lieu d'être logée dans le premier détecteur 10.

Au cours d'une étape préliminaire, le premier et le deuxième détecteur 10, 20 sont appairés pour les associer et configurés de sorte à assigner à chacun une fonction dans le procédé de détection S. Par exemple, le premier détecteur 10 peut être configuré comme détecteur maître tandis que le deuxième détecteur 20 est configuré comme détecteur esclave. Par détecteur maître d'une porte donnée, on comprendra ici le détecteur dont l'unité de traitement 6 est configurée pour calculer la valeur moyenne et/ou la valeur corrigée du signal, tandis par détecteur esclave, on comprendra l'autre détecteur de ladite porte donnée.

Au cours d'une première étape S1, l'un au moins parmi les premiers et les deuxièmes capteurs magnétiques 5 génère un signal indicatif de l'intensité d'un champ magnétique.

En pratique, lorsqu'un champ magnétique est détecté par l'un des capteurs magnétiques 5 du système de détection 1, tous les capteurs magnétiques 5 dudit système génèrent un signal représentatif de l'intensité du champ magnétique détecté, seule la puissance du signal de chaque capteur 5 étant différente.

Les signaux générés par les premiers et deuxièmes capteurs magnétiques 5 sont transmis à l'unité de traitement 6, le cas échéant par l'intermédiaire des interfaces de communication 7 du premier détecteur 10 et/ou du deuxième détecteur 20. Dans notre exemple, le premier détecteur 10 étant maître et comprenant l'unité de traitement 6, les signaux des deuxièmes capteurs magnétiques 5 sont transmis au premier détecteur 10 par l'interface de communication 7 du deuxième détecteur 20, tandis que les signaux des premiers capteurs magnétiques 5 peuvent lui être transmis directement par les premiers capteurs magnétiques 5.

Au cours d'une étape S2, l'unité de traitement 6 du détecteur maître calcule alors une valeur moyenne des signaux générés par chaque couple de capteurs magnétiques 5. Ici, l'unité de traitement 6 calcule donc une première valeur moyenne correspondant à un premier des couples de premier et deuxième capteurs magnétiques 5, et une deuxième valeur moyenne correspondant au deuxième des couples.

Bien entendu, lorsque les détecteurs ne comprennent chacun qu'un seul capteur 5, l'unité de traitement 6 ne calcule qu'une seule valeur moyenne à l'étape S2 correspondant à la valeur moyenne des signaux de ces deux capteurs magnétiques 5.

Comme indiqué plus haut, l'unité de traitement 6 peut calculer une valeur moyenne arithmétique des signaux ou, en variante, une valeur moyenne géométrique.

Dans une variante de réalisation, au lieu de calculer une valeur moyenne des signaux de chaque couple de capteurs magnétiques 5, l'unité de traitement 6 peut mettre en œuvre une étape S3 de correction des signaux générés par chacun des capteurs magnétiques 5 par application d'un coefficient d'atténuation auxdits signaux.

Cette étape S3 de correction permet ainsi d'atténuer les signaux générés par les capteurs magnétiques 5 du système de détection 1 en appliquant un coefficient de correction aux signaux dépendant de la valeur de ces signaux. Plus précisément, l'objectif de la correction est d'atténuer le signal lorsque l'objet cible est proche d'un des détecteurs 10, 20, où la sensibilité est plus forte, afin de réduire son poids dans la détection.

Pour cela, au cours de sous-étapes S31 et S32, pour chaque couple de capteurs magnétiques 5, l'unité de traitement 6 détermine la valeur maximale et la valeur minimale parmi les signaux générés par le premier capteur magnétique 5 et le deuxième capteur magnétique 5 à un instant donné.

Au cours d'une troisième sous-étape S33, l'unité de traitement 6 calcule un rapport entre la valeur maximale et la valeur minimale ainsi déterminées, puis, au cours d'une quatrième sous-étape S34, compare le rapport à des seuils déterminés et en déduit la valeur du coefficient d'atténuation à appliquer à la valeur des signaux.

Par exemple, l'unité de traitement 6 peut notamment comparer le rapport à un premier seuil et à un deuxième seuil, le deuxième seuil étant supérieur au premier seuil, et en déduire le coefficient d'atténuation. Ainsi, le coefficient d'atténuation peut être égal à :
- une première valeur lorsque le rapport est inférieur au premier seuil,
- une deuxième valeur inférieure à la première valeur lorsque le rapport est supérieur au deuxième seuil et
- une valeur comprise entre la première valeur et la deuxième valeur lorsque le rapport est compris entre le premier seuil et le deuxième seuil. En particulier, le coefficient d'atténuation peut être une fonction linéaire dépendant du rapport lorsque ledit rapport est compris entre le premier seuil et le deuxième seuil.

L'utilisation du rapport entre la valeur maximale et la valeur minimale permet de déterminer si l'objet cible qui génère un champ magnétique ou perturbe le champ électromagnétique terrestre est placé près de l'un des détecteurs. Dans ce cas, la valeur du rapport est supérieure au deuxième seuil et le coefficient d'atténuation qui est appliqué est égal à la deuxième valeur, qui est inférieure à la première valeur. Au contraire, lorsque l'objet cible est centré entre les deux détecteurs, la sensibilité de la porte dans cette zone est plus faible. Cela se traduit par un rapport entre la valeur maximale et la valeur minimale également plus faible. Le coefficient d'atténuation peut donc être plus élevé et l'atténuation résultante plus faible.

On obtient ainsi une relative uniformité virtuelle entre les deux détecteurs.

A titre d'exemple non limitatif, le premier seuil peut être égal à 30, le deuxième seuil peut être égal à 60, la première valeur peut être égale à 1, la deuxième valeur peut être égale à 0,1 et le coefficient d'atténuation peut être défini par la fonction suivante lorsque le rapport est compris entre le premier seuil et le deuxième seuil : $- 0 , 03 * R + 1 , 9$ où R est la valeur du rapport.

En d'autres termes, le coefficient d'atténuation peut être égal à 1 lorsque le rapport est inférieur à 30, 0,1 lorsque le rapport est supérieur à 60, et - 0,03*R + 1,9 lorsque le rapport est compris entre 30 et 60.

Dans une autre variante de réalisation, l'unité de traitement 6 peut à la fois calculer une moyenne des signaux pour chaque couple de capteurs magnétiques 5 (étape S2) et mettre en œuvre une étape de correction desdits signaux (étape S3).

Pour cela, après avoir calculé la moyenne des signaux de chaque couple de capteurs magnétiques 5 (étape S2), l'unité de traitement 6 peut appliquer un coefficient d'atténuation aux valeurs moyennes ainsi calculées (étape S3).

Alternativement, l'unité de traitement 6 peut d'abord appliquer le coefficient d'atténuation aux signaux de chaque couple de capteurs magnétiques 5 (étape S3) puis calculer une moyenne des signaux corrigés de chaque couple de capteurs magnétiques 5 (étape S2, appliquée aux signaux corrigés et non aux signaux générés par les capteurs magnétiques 5).

Le coefficient d'atténuation peut être identique à ce qui a été décrit précédemment (égal à la première valeur, la deuxième valeur ou fonction du rapport, selon la valeur du rapport).

Au cours d'une cinquième étape S5, l'unité de traitement 6 compare la valeur calculée à une valeur seuil prédéterminée.

La valeur calculée utilisée par l'unité de traitement 6 au cours de la cinquième étape S5 peut être soit la valeur moyenne des signaux générés par les couples de capteurs magnétiques 5 et obtenue à l'étape S2, soit la valeur moyenne corrigée par application d'un coefficient d'atténuation suite à l'étape S3. Lorsque la valeur moyenne, le cas échéant la valeur moyenne corrigée, est supérieure à la valeur seuil prédéterminée, au cours d'une sixième étape S6, l'unité de traitement 6 envoie des instructions d'émission d'une alarme (optique, sonore, etc.) à l'un au moins des émetteurs 8. De préférence, l'unité de traitement 6 envoie des instructions d'émission d'une alarme aux émetteurs 8 du premier détecteur 10 et du deuxième détecteur 20 (via les interfaces de communication 7), de sorte qu'une ou des alarmes soient émises des deux côtés de la porte. En variante, seul(s) le ou les émetteurs 8 de l'un des détecteurs 10, 20 peut recevoir les instructions d'émission de l'unité de traitement 6.

Dans une variante de réalisation, lorsque l'unité de traitement 6 détermine uniquement une valeur corrigée des signaux, sans en effectuer la moyenne, c'est la somme des valeurs corrigées des signaux (et non leur moyenne) qui est comparée au cours de l'étape S5 à la valeur seuil prédéterminée. Bien entendu, les signaux générés par les capteurs 5 peuvent d'abord être sommés avant que l'étape S3 de correction leur soit appliquée.

De manière alternative, au lieu de calculer la somme des valeurs corrigées des signaux, l'unité de traitement 6 peut déterminer la valeur maximale des signaux corrigés et comparer, au cours de l'étape S5, la valeur maximale ainsi déterminée à la valeur seuil. De manière analogue à ce qui a été décrit précédemment, il est possible de déterminer d'abord la valeur maximale des signaux générés par les capteurs 5 puis d'appliquer à cette valeur maximale l'étape de correction S3.

Dans cette variante de réalisation, l'unité de traitement 6 compare la somme des valeurs corrigées (respectivement, la valeur maximale corrigée) des signaux d'un même couple de capteurs magnétiques 5 à la valeur seuil prédéterminée. Lorsque cette somme (respectivement, cette valeur maximale corrigée) est supérieure à la valeur seuil prédéterminée, au cours de la sixième étape S6, l'unité de traitement 6 envoie des instructions d'émission d'une alarme (optique, sonore, etc.) à l'un au moins des émetteurs 8. Comme indiqué précédemment, l'unité de traitement 6 peut envoyer des instructions d'émission d'une alarme aux émetteurs 8 du premier détecteur 10 et/ou du deuxième détecteur 20.

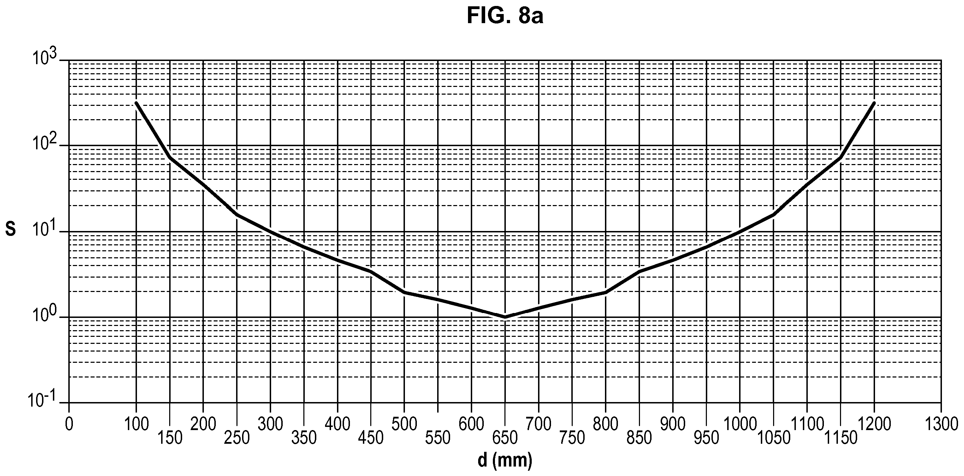

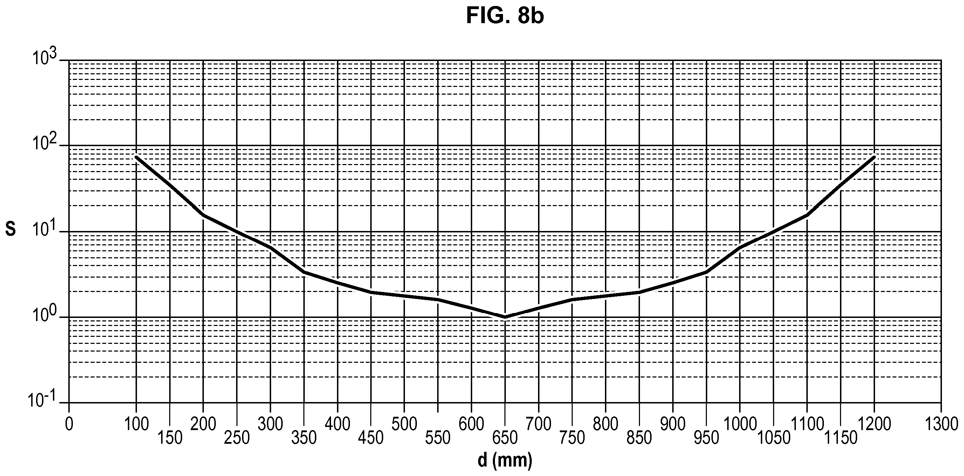

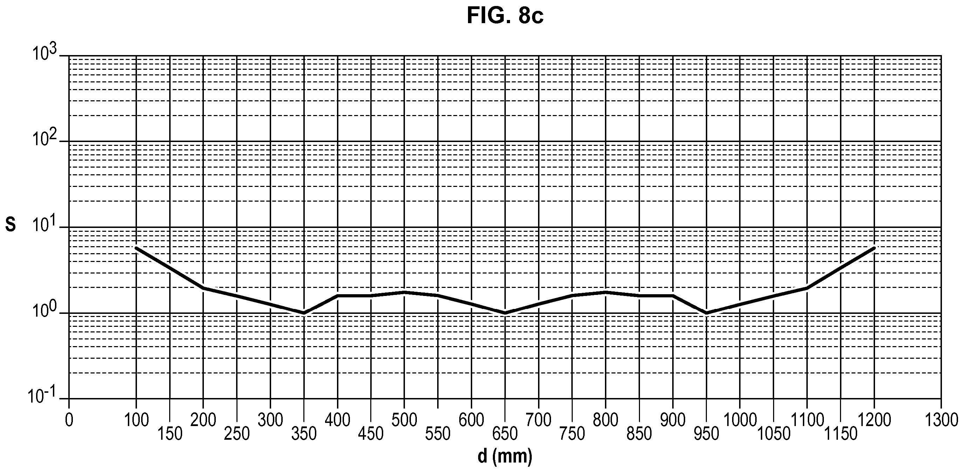

Les figures 8a, 8b et 8c illustrent l'intensité du signal mesurée pour quatre systèmes de détection en fonction de la distance par rapport au(x) détecteurs.

La figure 8a illustre le cas d'un système de détection conforme à l'art antérieur comprenant deux détecteurs séparés d'une distance de 130 cm. Sur cette figure, l'intensité représentée correspond à la valeur maximale des signaux générés par les capteurs des deux détecteurs.

La figure 8b illustre le cas d'un système de détection 1 conforme à un mode de réalisation de l'invention comprenant deux détecteurs séparés d'une distance de 130 cm et comprenant une unité de traitement. Sur cette figure, l'intensité représentée correspond à la valeur moyenne des signaux générés par les capteurs des deux détecteurs.

La figure 8c illustre le cas d'un système de détection 1 conforme à un mode de réalisation de l'invention comprenant deux détecteurs séparés d'une distance de 130 cm et comprenant une unité de traitement. Sur cette figure, l'intensité représentée correspond à la valeur moyenne corrigée des signaux générés par les capteurs des deux détecteurs.

Il ressort clairement de cette figure que le calcul de la valeur moyenne et, le cas échéant, l'application du coefficient d'atténuation lors de l'étape de correction de la valeur moyenne, permettent d'uniformiser l'intensité du signal entre les deux détecteurs du système de détection, en comparaison avec la simple détermination des valeurs maximales des signaux (figure 8a).

### Exemple

Le tableau ci-dessous est un exemple comparatif de détection d'un même objet cible par trois configurations de système de détection 1, à savoir (i) un système de détection 1 ne comprenant qu'un seul détecteur, (ii) un système de détection 1 conforme à un premier mode de réalisation de l'invention et comprenant deux détecteurs espacés de 130 cm avec calcul de la valeur moyenne des signaux et (iii) un système de détection 1 conforme à un deuxième mode de réalisation de l'invention et comprenant deux détecteurs espacés de 130 cm avec calcul de la valeur moyenne des signaux et correction de ladite valeur moyenne pour déterminer si une alarme doit être déclenchée.

Dans cet exemple, la sensibilité SE des trois configurations de système de détection a été réglée sur 85% (correspondant à 1400 mV). En d'autres termes, la sensibilité a été réglée de sorte la valeur seuil prédéterminée soit égale à 1400 mV. Les systèmes ont été paramétrés de sorte qu'à cette sensibilité, le passage d'une sphère de 75 mm de diamètre à une hauteur d'un mètre du sol ne génère pas d'alarme lorsqu'elle passe à 65 cm du détecteur unique (première configuration (i)) ni au milieu des deux détecteurs (deuxième et troisième configuration (ii) (iii)). En d'autres termes, le diamètre de 75 mm est un diamètre limite de détection par les systèmes testés. En effet, la perturbation du champ électromagnétique d'une sphère en fer de diamètre 75 mm correspond sensiblement à la perturbation engendrée par la présence d'un fusil d'assaut du type AK47 au centre de la porte.

| **Distance entre la sphère et l'un des détecteurs [cm]** | **Diamètre limite [mm]** | **Diamètre limite [mm]** | **Diamètre limite [mm]** |
|---|---|---|---|
| | **(i) Détecteur unique** | **(ii) Système à deux détecteurs avec calcul de la valeur moyenne** | **(iii) Système à deux détecteurs avec calcul de la valeur moyenne et correction de la valeur moyenne** |
| 10 | 11 | 18 | 35 |
| 15 | 18 | 23 | 50 |
| 20 | 23 | 30 | 60 |
| 25 | 30 | 35 | **64** |
| 30 | 35 | 40 | **69** |
| 35 | 40 | 50 | **75** |
| 40 | 45 | 55 | **64** |
| 45 | 50 | 60 | **64** |
| 50 | 60 | **62** | **62** |
| 55 | **64** | **64** | **64** |
| 60 | **69** | **69** | **69** |
| 65 | **75** | **75** | **75** |

Dans ce tableau, « diamètre limite [mm] » correspond au diamètre minimum en millimètres à partir duquel le système de détection 1 testé émet un signal d'alarme.

Les tests montrent que, dans le cas où le système de détection 1 comprend deux détecteurs formant une porte (configurations (ii) et (iii)) et que l'unité de traitement 6 calcule la valeur moyenne des signaux générés par les capteurs magnétiques 5 de ces détecteurs, celui-ci est capable de discriminer les objets cibles dont le champ magnétique est équivalent à celui d'une sphère en fer d'environ 62 mm des objets de plus petite taille tels que les smartphones, et ce même si l'objet cible est à 50 cm de l'un des détecteurs (ce qui, en pratique, est déjà assez éloigné du centre du passage, les détecteurs étant espacés de 130 cm lors ce test).

Dans le cas où l'unité de traitement 6 du système de détection 1 applique en outre une étape S2 de correction à la valeur moyenne des signaux (configuration (iii)), le système de détection 1 est en outre capable de discriminer les objets cibles dont le champ magnétique est équivalent à celui d'une sphère d'environ 64 mm, et ce même si l'objet cible est à 25 cm de l'un des détecteurs (soit très proches de celui-ci, les détecteurs étant espacés de 130 cm lors ce test).

Les systèmes de détection conformes à l'invention (configurations (ii) et (iii)) sont donc capables de discriminer des objets de petite taille, même si ceux-ci comprennent des éléments magnétiques (tels que des smartphones) d'objets cibles de grand volume tels que des fusils d'assaut, et ce même si le passage de la personne 2 inspectée n'est pas centré entre les détecteurs.

L'invention s'applique également au cas où le système de détection 1 comprend un nombre de détecteurs supérieur ou égal à trois de sorte à former une pluralité de portes et où deux portes adjacentes partageant un même détecteur. Un exemple de procédé de détection d'un objet cible à l'aide d'un tel système de détection 1 va à présent être décrit.

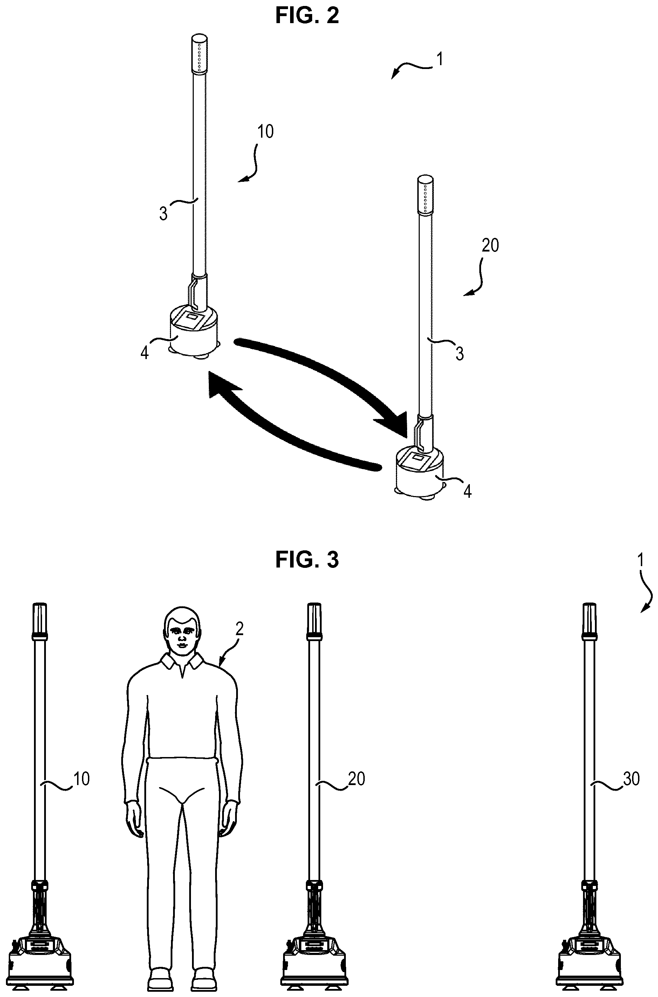

Afin de faciliter la lecture de ce mode de réalisation, le système de détection 1 comprend trois détecteurs comportant chacun deux capteurs magnétiques 5 (figure 3). En d'autres termes, le système de détection 1 comporte un premier, un deuxième et un troisième détecteur 10, 20, 30, comportant deux premiers, deux deuxièmes et deux troisièmes capteurs magnétiques 5, respectivement. Le deuxième détecteur 20 forme une première porte avec le premier détecteur 10 et une deuxième porte avec le troisième détecteur 30. Le deuxième détecteur 20 se situe donc entre le premier détecteur 10 et le troisième détecteur 30.

Les trois détecteurs sont identiques et comprennent donc chacun une unité de traitement 6 et une interface de communication 7. Bien entendu, l'unité de traitement 6 pourrait en variante être placée à distance des détecteurs et ne pas être intégrée aux détecteurs. Dans ce cas, les signaux générés par les capteurs magnétiques 5 d'un détecteur donné sont transmis à l'unité de traitement 6 distante par l'intermédiaire des interfaces de communication 7 des détecteurs afin qu'elle leur applique l'algorithme de détection et qu'elle transmette ensuite les éventuelles instructions de génération d'alarme aux émetteurs 8 des détecteurs, via leurs interfaces de communication 7 respectives.

Bien entendu, l'invention s'applique mutatis mutandis dans le cas où le système ne comprend que deux détecteurs formant ensemble une unique porte ou un plus grand nombre de détecteurs (par exemple *n* détecteurs, *n* étant un nombre entier) formant ensemble *n* - *1* portes. Les détecteurs pourraient en outre ne comprendre qu'un seul capteur magnétique 5, ou plus de deux capteurs magnétiques 5 (par exemple trois capteurs magnétiques 5).

Au cours d'une étape préliminaire, le premier, le deuxième et le troisième détecteur 10, 20, 30 sont appariés pour les associer et configurés de sorte à assigner à chacun une fonction dans le procédé de détection S. Par exemple, pour la première porte, le premier détecteur 10 peut être configuré comme détecteur maître tandis que le deuxième détecteur 20 est configuré comme détecteur esclave. Pour la deuxième porte, le deuxième détecteur 20 est configuré comme détecteur maître tandis que le troisième détecteur 30 est configuré comme détecteur esclave. Lors de l'appariement, les moyens d'identification de chaque détecteur du système (typiquement, leur adresse) sont en outre renseignés et enregistrés dans la mémoire de chacun des détecteurs adjacents. Ainsi, les moyens d'identification du premier détecteur 10 sont renseignés dans le deuxième détecteur 20 tandis que les moyens d'identification du deuxième détecteur 20 sont renseignés dans le premier détecteur 10 de sorte à permettre leur appariement. De même, les moyens d'identification du deuxième détecteur 20 sont renseignés dans le troisième détecteur 30, tandis que les moyens d'identification du troisième détecteur 30 sont renseignés dans le deuxième détecteur 20.

Au cours d'une première étape, l'un au moins parmi les premiers, deuxièmes et troisièmes capteurs magnétiques 5 détecte un champ magnétique et génère un signal indicatif de l'intensité du champ magnétique ainsi détecté.

En pratique, tous les capteurs magnétiques 5 d'une même porte génèrent, de façon continue ou périodique, un signal représentatif de l'intensité d'un champ magnétique, seule la puissance du signal généré par chaque capteur 5 étant différente.

Dans ce qui suit, un exemple dans lequel un signal est généré par les deux deuxièmes capteurs magnétiques 5 et les deux troisièmes capteurs magnétiques 5 est décrit pour illustrer les étapes du procédé S.

Le signal généré par les capteurs magnétiques 5 est alors transmis à l'unité de traitement 6 du détecteur maître de la porte concernée, le cas échéant par l'intermédiaire d'interfaces de communication 7. Dans l'exemple décrit, le signal généré par les troisièmes capteurs magnétiques 5 est transmis par l'interface de communication 7 du troisième détecteur 30 à l'unité de traitement 6 du deuxième détecteur 20. Le signal généré par les deuxièmes capteurs magnétiques 5 quant à lui est transmis directement à l'unité de traitement 6 du deuxième détecteur 20 (sachant qu'il serait transmis via son interface de communication 7 dans le cas où l'unité de traitement 6 serait externe).

Au cours d'une deuxième étape, l'unité de traitement 6 du détecteur maître de la porte concernée, ici le deuxième détecteur 20, calcule une valeur moyenne PGS[2, 3] des signaux générés pour chaque couple de capteurs magnétiques 5. Ici, l'unité de traitement 6 calcule donc une première valeur moyenne correspondant à un premier des couples de deuxième et troisième capteurs magnétiques 5 et une deuxième valeur moyenne correspondant au deuxième des couples.

Bien entendu, lorsque les détecteurs ne comprennent chacun qu'un seul capteur 5, l'unité de traitement 6 ne calcule qu'une seule valeur moyenne correspondant à la valeur moyenne des signaux de ces deux capteurs magnétiques 5.

Comme indiqué plus haut, l'unité de traitement 6 peut calculer une valeur moyenne arithmétique des signaux ou, en variante, une valeur moyenne géométrique.

Dans une variante de réalisation, au lieu de calculer une valeur moyenne des signaux de chaque couple de capteurs magnétiques 5, l'unité de traitement 6 peut mettre en œuvre une étape de correction des signaux générés par chacun des capteurs magnétiques 5 par application d'un coefficient d'atténuation auxdits signaux, puis calculer une valeur correspondant à la somme des valeurs des signaux ainsi corrigés (ou en variante déterminer la valeur maximale des signaux corrigés, pour chaque couple de capteurs 5). Cette étape de correction ayant déjà été décrite plus haut en relation avec les sous-étapes S31 à S35, elle ne sera pas davantage détaillée ici. Dans une autre variante de réalisation, l'unité de traitement 6 peut à la fois calculer une valeur moyenne des signaux pour chaque couple de capteurs magnétiques 5 et mettre en œuvre une étape de correction desdits signaux, comme décrit ci-dessus de sorte à obtenir une valeur moyenne corrigée.

De manière analogue à ce qui a déjà été décrit, l'étape S2 de correction peut être appliquée soit aux signaux générés par les capteurs 5, soit à la somme des signaux (ou à leur valeur maximale), soit à la valeur moyenne des signaux.

Au cours d'une troisième étape, lorsque l'une des valeurs calculées PGS[2, 3] à la deuxième étape est supérieure à la valeur seuil prédéterminée, l'unité de traitement 6 du deuxième détecteur 20 transmet à l'unité de traitement 6 du premier détecteur 10 d'une part ladite valeur calculée PGS[2, 3] et d'autre part les signaux générés par ses deuxièmes capteurs magnétiques 5.

Au cours quatrième étape, simultanée à la troisième étape, l'unité de traitement 6 du premier détecteur 10 calcule une valeur PGS[1, 2] à partir des signaux générés pour chaque couple de capteurs magnétiques 5 de la première porte. Le calcul de la valeur effectué par l'unité de traitement 6 du premier détecteur 10 est le même que celui effectué par l'unité de traitement 6 du deuxième détecteur 20. En d'autres termes, lorsqu'un des détecteurs maîtres calcule une valeur moyenne (ou, respectivement, une valeur moyenne corrigée, une valeur correspondant à la somme des valeurs corrigées ou une valeur maximale corrigée), les autres détecteurs maîtres effectuent le même calcul (respectivement, calcul de la valeur moyenne, d'une valeur moyenne corrigée, d'une valeur correspondant à la somme des valeurs corrigées ou d'une valeur maximale corrigée).

Ici, l'unité de traitement 6 du premier détecteur 10 calcule par exemple une première valeur moyenne correspondant à un premier des couples de premier et deuxième capteurs magnétiques 5, et une deuxième valeur moyenne correspondant au deuxième couple de sorte à obtenir des valeurs moyennes des signaux.

Lorsque la valeur PGS[1, 2] calculée par le premier détecteur 10 est inférieure à la valeur seuil prédéterminée, l'unité de traitement 6 du premier détecteur 10 n'envoie pas d'instructions de génération d'une alarme aux émetteurs 8 du premier détecteur 10 ni du deuxième détecteur 20.

En revanche, lorsque la valeur PGS[1, 2] calculée par le premier détecteur 10 est supérieure à la valeur seuil prédéterminée, au cours d'une cinquième étape, l'unité de traitement 6 du premier détecteur 10, en tant que détecteur maître de la première porte, détermine si l'objet cible a été détecté par la première porte (formée du premier et du deuxième détecteur 10, 20) ou par la deuxième porte (formée du deuxième et du troisième détecteur 20, 30).

Pour cela, l'unité de traitement 6 du premier détecteur 10 compare les valeurs PGS[2, 3] calculées (valeurs moyennes avec ou sans correction, somme ou valeur maximale corrigée) par le deuxième détecteur 20 et les valeurs PGS[1, 2] calculées par le premier détecteur 10.

A cet effet, au cours d'une première sous-étape, l'unité de traitement 6 du premier détecteur 10 multiplie la valeur PGS[2, 3] calculée à partir des signaux générés par les deuxièmes et troisièmes capteurs 5 par un coefficient de sécurité prédéfini Ks : Ks* PGS[2, 3]. Le coefficient de sécurité Ks est supérieur ou égal à 1, par exemple égal à 1.5 ou 2.

En parallèle, au cours d'une deuxième sous-étape, l'unité de traitement 6 du deuxième détecteur 10 multiplie la valeur PGS[1, 2] calculée à partir des signaux générés par les premiers et deuxièmes capteurs 5 par le coefficient de sécurité prédéfini Ks : Ks* PGS[1, 2].

Au cours d'une troisième sous-étape, le premier détecteur 10 compare la valeur PGS[1, 2] à la valeur Ks*PGS[2, 3] qu'il a calculée à partir des signaux générés par les premiers et deuxièmes capteurs 5. Si la valeur PGS[1, 2] calculée à partir des signaux générés par les premiers et deuxièmes capteurs 5 est inférieure à la valeur Ks*PGS[2, 3] obtenue en multipliant le coefficient de sécurité Ks par la valeur calculée à partir des signaux générés par les deuxièmes et troisièmes capteurs 5 (c'est-à-dire si PGS[1, 2] < Ks*PGS[2, 3]), l'unité de traitement 6 du premier détecteur 10 supprime ou n'envoie pas d'instructions de génération d'alarme aux émetteurs 8 du premier et du deuxième détecteur 10, 20.

En parallèle, au cours d'une quatrième sous-étape, le deuxième détecteur 20 compare la valeur PGS[2, 3] à la valeur Ks*PGS[1, 2] obtenue en multipliant Ks par la valeur des signaux générés par les premiers et deuxièmes capteurs 5. Si la valeur PGS[2, 3] calculée à partir des signaux générés par les deuxièmes et troisièmes capteurs 5 est inférieure à la valeur Ks*PGS[1, 2] obtenue en multipliant le coefficient de sécurité Ks par la valeur calculée à partir des signaux générés par les premiers et deuxièmes capteurs 5 (c'est-à-dire si PGS[2, 3] < Ks*PGS[1, 2]), l'unité de traitement 6 du deuxième détecteur 20 supprime ou n'envoie pas d'instructions de génération d'alarme aux émetteurs 8 du deuxième et du troisième détecteur 20, 30. Dans le cas contraire, si PGS[2, 3] > Ks*PGS[1, 2], le deuxième détecteur 20 envoie des instructions d'émission d'alarme aux émetteurs 8 du deuxième détecteur 20 et du troisième détecteur 30.

Un opérateur peut alors facilement identifier quelle porte (ici, la deuxième) a détecté un objet cible.

On notera que l'application d'un coefficient de sécurité Ks lors de la comparaison des valeurs calculées par les détecteurs de part et d'autre d'une porte donnée confère une marge dans la détection des objets cibles et réduit les risques de fausses alarmes.

Ainsi, l'envoi au détecteur maître d'une porte par le détecteur esclave de cette porte de la valeur calculée (valeur moyenne avec ou sans correction ou somme des valeurs corrigées) pour la porte adjacente, pour laquelle ce même détecteur est maître, permet de déterminer l'emplacement de l'objet cible qui a été détecté. On rappellera en effet que la détection par les capteurs magnétiques 5 est scalaire est qu'un détecteur partageant deux portes adjacentes (ici le deuxième détecteur 20) n'est pas capable de déterminer de quel côté se situe l'objet cible qu'il a détecté.

Le procédé de détection S de l'invention peut être généralisé à tout système de détection 1 comprenant *m* détecteurs, ou *m* est supérieur ou égal à 4 de manière à former *m* - *1* portes et où deux portes adjacentes ont un même détecteur en commun.

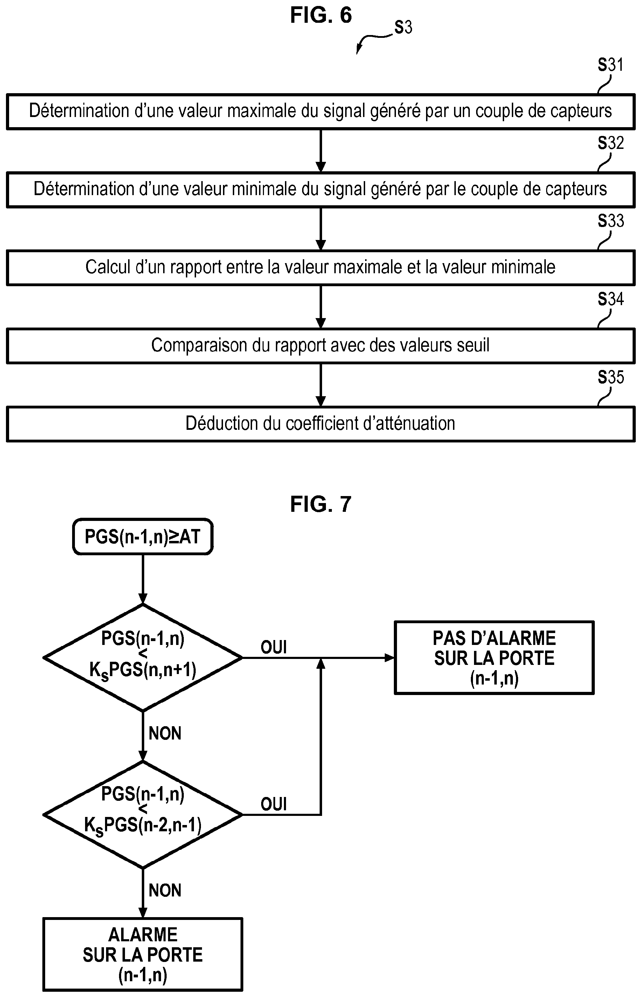

Le procédé de détection S comprend alors les mêmes étapes que celles décrites précédemment concernant un système de détection 1 à trois détecteurs. Toutefois, dans ce cas, lorsqu'un détecteur *n* - *1* a calculé une valeur PGS[n - 1 ; n] supérieure à la valeur seuil prédéterminée AT, le procédé de détection S comprend, en plus des étapes de comparaison de cette valeur PGS[n - 1 ; n] et de celle calculée par le détecteur *n* - 2 (PGS[n - 2 ; n - 1]), une étape de comparaison de cette valeur PGS[n - 1 ; n] à celle calculée par le détecteur n (PGS[n ; n + 1]) afin de déterminer la porte au sein de laquelle un objet cible a été détecté (voir figure 7). Le cas échéant, le coefficient de sécurité Ks (Ks ≥ 1) est appliqué à la valeur PGS[n ; n + 1] lors de l'étape de comparaison.

Par exemple, le détecteur *n* - *1* calcule une valeur donnée PGS[n - 1 ; n], typiquement une valeur moyenne (éventuellement corrigée), à partir des valeurs des signaux générés par les capteurs magnétiques 5 des détecteurs *n* et *n - 1.* Le détecteur *n* - *1* (en tant que détecteur esclave) envoie ensuite cette valeur calculée PGS[n - 1 ; n] au détecteur *n* - *2* (en tant que détecteur maître) ainsi que les valeurs des signaux générés par ses capteurs magnétiques 5. Le détecteur *n* - 2 calcule alors une valeur PGS[n - 2 ; n - 1], ici une valeur moyenne (éventuellement corrigée), à partir des valeurs des signaux générés par les capteurs magnétiques 5 des détecteurs *n - 2* et *n - 1.* De même, le détecteur *n* (en tant que détecteur esclave du détecteur *n - 1*) calcule et envoie la valeur calculée PGS[n ; n + 1] au détecteur *n* - *1* ainsi que les valeurs des signaux générés par ses capteurs magnétiques 5. Si la valeur calculée par le détecteur *n* - *2* (en tant que détecteur maître) est supérieure à la valeur seuil prédéterminée :
- le détecteur *n* - *2 :*
   ▪ multiplie la valeur PGS[n - 1 ; n] calculée et transmise par le détecteur *n* - *1* par le coefficient de sécurité Ks et
   ▪ compare la valeur qu'il a calculée PGS[n - 2 ; n - 1] à la valeur qu'il a multipliée Ks*PGS[n - 1 ; n]. Si la valeur PGS[n - 2 ; n - 1] qu'il a calculée est inférieure à la valeur calculée par le détecteur *n* - *1* et multipliée par le coefficient Ks (c'est-à-dire si PGS[n - 2 ; n - 1] < Ks*PGS[n - 1 ; n]), le détecteur *n* - *2* en déduit qu'aucune alarme ne doit être générée par la porte formée des détecteurs *n* - *2* et *n* - *1.* Le détecteur *n* - *2* n'envoie donc pas d'instructions de génération d'une alarme aux émetteurs 8 des détecteurs *n* - *2* et *n-1* (ou, le cas échéant, annule les instructions d'émission d'une alarme).
- le détecteur *n* - *1,* en parallèle :
   ▪ multiplie la valeur PGS[n - 2 ; n - 1] calculée et transmise par le détecteur *n* - *2* par le coefficient de sécurité Ks et
   ▪ compare la valeur qu'il a calculée PGS[n - 1 ; n] à la valeur qu'il a multipliée Ks*PGS[n - 2 ; n - 1].
      Si la valeur PGS[n - 1; n] qu'il a calculée est inférieure à la valeur calculée par le détecteur *n* - *2* et multipliée par le coefficient Ks (c'est-à-dire si PGS[n - 1 ; n] < Ks*PGS[n - 2 ; n - 1 ]), le détecteur *n* - *1* en déduit qu'aucune alarme ne doit être générée par la porte formée des détecteurs *n -1* et *n.* Le détecteur *n* - *1* n'envoie donc pas d'instructions de génération d'une alarme aux émetteurs 8 des détecteurs *n* - *1* et *n* (ou, le cas échéant, annule les instructions d'émission d'une alarme).
   ▪ multiplie la valeur PGS[n ; n + 1] calculée et transmise par le détecteur *n* par le coefficient de sécurité Ks et
   ▪ compare la valeur qu'il a calculée PGS[n - 1 ; n] à la valeur qu'il a multipliée Ks*PGS[n ; n + 1].
      Si la valeur PGS[n - 1 ; n] qu'il a calculée est inférieure à la valeur calculée par le détecteur *n* et multipliée par le coefficient Ks (c'est-à-dire si PGS[n - 1 ; n] < Ks*PGS[n ; n + 1]), le détecteur *n* - *1* en déduit qu'aucune alarme ne doit être générée par la porte formée des détecteurs *n -* 1 et *n.* Le détecteur *n-1* n'envoie donc pas d'instructions de génération d'une alarme aux émetteurs 8 des détecteurs *n -* 1 et *n* (ou, le cas échéant, annule les instructions d'émission d'une alarme).
- le détecteur n, en parallèle :
   ▪ multiplie la valeur PGS[n - 1 ; n] calculée et transmise par le détecteur *n -* 1 par le coefficient de sécurité Ks et
   ▪ compare la valeur qu'il a calculée PGS[n ; n+1] à la valeur qu'il a multipliée Ks*PGS[n - 1 ; n].
      Si la valeur PGS[n; n + 1] qu'il a calculée est inférieure à la valeur calculée par le détecteur *n -* 1 et multipliée par le coefficient Ks (c'est-à-dire si PGS[n ; n+1] < Ks*PGS[n-1 ; n]), le détecteur *n* en déduit qu'aucune alarme ne doit être générée par la porte formée des détecteurs *n* et *n* + *1.* Le détecteur *n* n'envoie donc pas d'instructions de génération d'une alarme aux émetteurs 8 des détecteurs *n* et *n* + 1 (ou, le cas échéant, annule les instructions d'émission d'une alarme).

On notera que, lorsque les portes adjacentes ne partagent pas un même détecteur et sont chacune formées de deux détecteurs distincts, la détection est réalisée au sein de chaque porte par les couples de détecteurs. Les détecteurs d'une porte donnée ne communiquent donc pas nécessairement avec les détecteurs d'une porte adjacente. Chaque porte peut en effet fonctionner indépendamment, puisqu'il n'est pas nécessaire de déterminer la porte par laquelle est passé l'objet cible.

## Revendications

1. Système de détection (1) d'un objet cible comprenant :
- un premier détecteur (10) comprenant au moins un premier capteur (5) magnétique configuré pour générer un premier signal indicatif d'une intensité d'un champ magnétique détecté et au moins un émetteur (8),
- un deuxième détecteur (20) distinct du premier détecteur (10) et comprenant au moins un deuxième capteur (5) magnétique configuré pour générer un deuxième signal indicatif d'une intensité d'un champ magnétique détecté et au moins un émetteur (8),
- soit une unité de traitement (6) configurée pour recevoir le premier signal généré par le premier capteur magnétique (5) et le deuxième signal généré par le deuxième capteur magnétique (5), soit une unité de traitement (6) configurée pour recevoir le premier signal généré par le premier capteur magnétique (5) et une unité de traitement (6) configurée pour recevoir le deuxième signal généré par le deuxième capteur magnétique (6),
- une interface de communication (7), ladite interface étant configurée pour transmettre le premier et le deuxième signal à l'unité de traitement (6), au moins une des unités de traitement (6) étant configurée pour envoyer des instructions de génération d'une alarme à l'émetteur (8) du premier détecteur (10) et/ou du deuxième détecteur (20),
le système de détection (1) étant **caractérisé en ce que** l'interface de communication (7) est configurée pour transmettre le deuxième signal à l'unité de traitement (6) recevant le premier signal, cette unité de traitement (6) étant configurée pour calculer une valeur basée sur chacun des premier et deuxième signaux, pour comparer la valeur calculée à une valeur seuil prédéterminée et, lorsque ladite valeur calculée est supérieure à la valeur seuil prédéterminée, pour envoyer des instructions de génération d'une alarme à l'émetteur (8) du premier détecteur (10) et/ou du deuxième détecteur (20).

2. Système de détection (1) selon la revendication 1, dans lequel la valeur calculée comprend une valeur moyenne du premier signal et du deuxième signal et/ou une valeur corrigée par application d'un coefficient d'atténuation aux premier et deuxième signaux.

3. Système de détection (1) selon l'une des revendications 1 et 2, dans lequel le premier et le deuxième détecteur (10, 20) sont portables et l'interface de communication (7) est sans fil.

4. Système de détection (1) selon l'une des revendications 1 à 3, comprenant en outre un troisième détecteur (30) et dans lequel :
- le troisième détecteur (30) comprend au moins un troisième capteur (5) magnétique configuré pour détecter un champ magnétique et générer un troisième signal indicatif d'une intensité du champ magnétique ainsi détecté,
- le premier détecteur (10) et le deuxième détecteur (20) forment une première porte et le deuxième détecteur (20) et le troisième détecteur (30) forment ensemble une deuxième porte,
- une unité de traitement (6) est logée dans chacun des premier et deuxième détecteurs (10, 20) et
- l'unité de traitement (6) logée dans le deuxième détecteur (20) est configurée pour envoyer des instructions de génération d'une alarme au deuxième détecteur (20) et au troisième détecteur (20).

5. Procédé de détection (S) d'un objet cible à l'aide d'un système de détection (1) selon l'une des revendications 1 à 4, ledit procédé de détection (S) comprenant les étapes suivantes :
S1 : génération par le premier et le deuxième capteur (5) magnétique d'un premier signal et d'un deuxième signal indicatifs d'une intensité d'un champ magnétique,
S2 : calcul par l'unité de traitement (6) d'une valeur basée sur chacun des premier et deuxième signaux générés par le premier et le deuxième capteur (5) magnétique de sorte à obtenir une valeur calculée,
S4: comparaison de la valeur calculée à une valeur seuil prédéterminée, et
S5: lorsque la valeur calculée est supérieure à la valeur seuil prédéterminée, envoi d'instructions de génération d'une alarme au premier détecteur (10) et/ou au deuxième détecteur (20) en utilisant l'interface de communication (7).

6. Procédé de détection (S) selon la revendication 5, dans lequel le premier détecteur comprend l'unité de traitement (6) et une interface de communication (7) et le deuxième détecteur (20) comprend une interface de communication (7), le procédé comprenant en outre une étape de transmission du deuxième signal généré par le deuxième capteur magnétique (5) à l'unité de traitement (6) via les interfaces de communication (7).

7. Procédé selon l'une des revendications 5 ou 6, dans lequel l'étape de traitement (S2) comprend l'une des sous-étapes suivantes :
- calcul, à partir des premier et deuxième signaux, d'une valeur moyenne desdits signaux,
- calcul, à partir des premier et deuxième signaux, d'une valeur moyenne desdits signaux et correction (S3) de la valeur moyenne de sorte à obtenir une valeur moyenne corrigée par application d'un coefficient d'atténuation à la valeur moyenne,
- correction des premier et deuxième signaux générés de sorte à obtenir des valeurs corrigées par application d'un coefficient d'atténuation auxdits signaux, et calcul d'une valeur moyenne à partir des signaux corrigés,
- correction des premier et deuxième signaux de sorte à obtenir des valeurs corrigées par application d'un coefficient d'atténuation auxdits signaux, et calcul d'une somme desdites valeurs corrigées,
- correction des premier et deuxième signaux de sorte à obtenir des valeurs corrigées par application d'un coefficient d'atténuation auxdits signaux, et détermination d'une valeur maximale desdites valeurs corrigées,
- détermination, à partir des premier et deuxième signaux, d'une somme des signaux et correction de ladite somme par application d'un coefficient d'atténuation à ladite somme,
- détermination, à partir des premier et deuxième signaux, d'une valeur maximale des signaux et correction de ladite valeur maximale par application d'un coefficient d'atténuation à ladite valeur maximale.

8. Procédé de détection (S) selon la revendication 7, dans lequel le coefficient d'atténuation est calculé conformément aux sous-étapes suivantes :
S31 : détermination d'une valeur maximale du premier signal et du deuxième signal,
S32 : détermination d'une valeur minimale du premier signal et du deuxième signal,
S32 : calcul d'un rapport entre la valeur maximale et la valeur minimale ainsi déterminées,
S34 : comparaison du rapport à un premier seuil et à un deuxième seuil, le deuxième seuil étant supérieur au premier seuil, et
S35 : déduction du coefficient d'atténuation
- le coefficient d'atténuation étant égal à :
- une première valeur lorsque le rapport est inférieur au premier seuil,
- une deuxième valeur différente de la première valeur lorsque le rapport est supérieur au deuxième seuil et
une valeur comprise entre la première valeur et la deuxième valeur lorsque le rapport est compris entre le premier seuil et le deuxième seuil, le coefficient d'atténuation étant une fonction linéaire dépendant du rapport lorsque ledit rapport est compris entre le premier seuil et le deuxième seuil.

9. Procédé de détection (S) selon l'une des revendications 5 à 8, dans lequel le premier détecteur (10) comprend au moins deux premiers capteurs (5) magnétiques et le deuxième détecteur (20) comprend au moins deux deuxièmes capteurs (5) magnétiques, chaque premier capteur (5) magnétique étant associé à un deuxième capteur (5) magnétique donné de sorte à former un couple, et dans lequel les étapes S1 à S4 sont appliquées à chaque couple.

10. Procédé de détection (S) selon l'une des revendications 5 à 9, dans lequel le système de détection (1) comprend en outre un troisième détecteur (30), ledit troisième détecteur (30) comprenant au moins un troisième capteur (5) magnétique configuré pour détecter un champ magnétique et générer un troisième signal indicatif d'une intensité du champ magnétique ainsi détecté, le procédé de détection (S) comprenant en outre :
préalablement à l'étape S5 de génération d'une alarme, une étape de traitement des deuxième et troisième signaux de sorte à obtenir une valeur traitée ; et
une étape de déduction, à partir de la valeur traitée des premier et deuxième signaux et de la valeur traitée des deuxième et troisième signaux, de la ou des portes formées par le premier détecteur (10) et le deuxième détecteur (20), d'une part, et le deuxième détecteur (20) et le troisième détecteur (30) d'autre part, ayant détecté le champ magnétique.

11. Procédé de détection (S) selon la revendication 10, dans lequel l'étape de déduction de la ou des portes comprend les sous-étapes suivantes :
- multiplication de la valeur traitée calculée à partir des deuxième et troisième signaux par un coefficient de sécurité (Ks),
- comparaison de la valeur traitée calculée à partir des premier et deuxième signaux à la valeur traitée calculée à partir des deuxième et troisième signaux et multipliée par le coefficient de sécurité (Ks),
- multiplication de la valeur traitée calculée à partir des premier et deuxième signaux par le coefficient de sécurité (Ks),
- comparaison de la valeur traitée calculée à partir des deuxième et troisième signaux à la valeur traitée calculée à partir des premier et deuxième signaux et multipliée par le coefficient de sécurité (Ks).

12. Procédé de détection (S) selon la revendication 11, dans lequel :
- l'étape S5 n'est mise en œuvre par les premier et deuxième détecteurs (10, 20) que si la valeur traitée calculée à partir des premier et deuxième signaux est supérieure à la valeur traitée calculée à partir des deuxième et troisième signaux multipliée par le coefficient de sécurité (Ks) et
- l'étape S5 n'est mise en œuvre par les deuxième et troisième détecteurs (20, 30) que si la valeur traitée calculée à partir des deuxième et troisième signaux est supérieure à la valeur traitée calculée à partir des premier et deuxième signaux et multipliée par le coefficient de sécurité (Ks).

13. Procédé selon l'une des revendications 10 à 12, dans lequel le premier détecteur (10) et le deuxième détecteur (20) comprennent chacun une unité de traitement (6), et dans lequel :
- l'étape de calcul de la valeur traitée des deuxième et troisième signaux est réalisée par l'unité de traitement (6) du deuxième détecteur (20),
- l'étape de calcul de la valeur traitée des premier et deuxième signaux est réalisée par l'unité de traitement (6) du premier détecteur (10) et
- l'étape de déduction du ou des couples de détecteurs (10, 20, 30) ayant détecté le champ magnétique est réalisée par l'unité de traitement (6) du deuxième détecteur (20) et par l'unité de traitement (6) du premier détecteur (10).

14. Procédé de détection (S) selon la revendication 11, dans lequel le système de détection (1) comprend en outre un quatrième détecteur (n + 1), ledit quatrième détecteur (n + 1) comprenant au moins un quatrième capteur (5) magnétique configuré pour détecter un champ magnétique et générer un quatrième signal indicatif d'une intensité du champ magnétique ainsi détecté, le procédé de détection (S) comprenant en outre les sous-étapes suivantes :
- calcul d'une valeur traitée des troisième et quatrième signaux,
- multiplication de la valeur traitée des troisième et quatrième signaux par le coefficient de sécurité (Ks),
- comparaison de la valeur traitée des deuxième et troisième signaux à la valeur traitée des troisième et quatrième signaux multipliée par le coefficient de sécurité (Ks),
- comparaison de la valeur traitée des troisième et quatrième signaux à la valeur traitée des deuxième et troisième signaux multipliée par le coefficient de sécurité (Ks) et
- déduction du ou des couples de détecteurs parmi les premier, deuxième, troisième et quatrième détecteurs (10, 20, 30, n + 1) ayant détecté le champ magnétique.

15. Procédé de détection selon la revendication 14, dans lequel :
- l'étape S5 n'est mise en œuvre par le deuxième et le troisième détecteur (20, 30) que si la valeur traitée des deuxième et troisième signaux est supérieure à la valeur traitée des troisième et quatrième signaux multipliée par le coefficient de sécurité (Ks) et
- l'étape S5 n'est mise en œuvre par le troisième et le quatrième détecteur (10, 20) que si la valeur traitée des troisième et quatrième signaux est supérieure à la valeur traitée des deuxième et troisième signaux multipliée par le coefficient de sécurité (Ks).

## Patentansprüche

1. System (1) zur Detektion eines Zielobjekts, umfassend:
- einen ersten Detektor (10), der mindestens einen ersten Magnetsensor (5) umfasst, der so konfiguriert ist, dass er ein erstes Signal erzeugt, das eine Stärke eines erfassten Magnetfelds angibt, und mindestens einen Sender (8),
- einen vom ersten Detektor (10) verschiedenen zweiten Detektor (20), der mindestens einen zweiten Magnetsensor (5) umfasst, der so konfiguriert ist, dass er ein zweites Signal erzeugt, das eine Stärke eines erfassten Magnetfelds angibt, und mindestens einen Sender (8),
- entweder eine Verarbeitungseinheit (6), die so konfiguriert ist, dass sie das von dem ersten Magnetsensor (5) erzeugte erste Signal und das von dem zweiten Magnetsensor (5) erzeugte zweite Signal empfängt, oder eine Verarbeitungseinheit (6), die so konfiguriert ist, dass sie das von dem ersten Magnetsensor (5) erzeugte erste Signal empfängt, und eine Verarbeitungseinheit (6), die so konfiguriert ist, dass sie das von dem zweiten Magnetsensor (6) erzeugte zweite Signal empfängt,
- eine Kommunikationsschnittstelle (7), wobei die Schnittstelle so konfiguriert ist, dass sie das erste und das zweite Signal an die Verarbeitungseinheit (6) überträgt, wobei mindestens eine der Verarbeitungseinheiten (6) so konfiguriert ist, dass sie Befehle zur Auslösung eines Alarms an den Sender (8) des ersten Detektors (10) und/oder des zweiten Detektors (20) schickt,
wobei das Detektionssystem (1) **dadurch gekennzeichnet ist, dass** die Kommunikationsschnittstelle (7) so konfiguriert ist, dass sie das zweite Signal an die Verarbeitungseinheit (6) überträgt, die das erste Signal empfängt, wobei diese Verarbeitungseinheit (6) so konfiguriert ist, dass sie einen Wert berechnet, der sowohl auf dem ersten als auch dem zweiten Signal basiert, den berechneten Wert mit einem vorgegebenen Schwellenwert vergleicht und, wenn der berechnete Wert größer als der vorgegebene Schwellenwert ist, Befehle zur Auslösung eines Alarms an den Sender (8) des ersten Detektors (10) und/oder des zweiten Detektors (20) schickt.

2. Detektionssystem (1) nach Anspruch 1, wobei der berechnete Wert einen Mittelwert des ersten Signals und des zweiten Signals und/oder einen durch Anwendung eines Dämpfungskoeffizienten auf das erste und das zweite Signal korrigierten Wert umfasst.

3. Detektionssystem (1) nach einem der Ansprüche 1 und 2, wobei der erste und der zweite Detektor (10, 20) tragbar sind und die Kommunikationsschnittstelle (7) drahtlos ist.

4. Detektionssystem (1) nach einem der Ansprüche 1 bis 3, das ferner einen dritten Detektor (30) umfasst und wobei:
- der dritte Detektor (30) mindestens einen dritten Magnetsensor (5) umfasst, der so konfiguriert ist, dass er ein Magnetfeld erfasst und ein drittes Signal erzeugt, das eine Stärke des so erfassten Magnetfelds angibt,
- der erste Detektor (10) und der zweite Detektor (20) einen ersten Port bilden und der zweite Detektor (20) und der dritte Detektor (30) gemeinsam einen zweiten Port bilden,
- sowohl in dem ersten als auch in dem zweiten Detektor (10, 20) eine Verarbeitungseinheit (6) untergebracht ist, und
- die in dem zweiten Detektor (20) untergebrachte Verarbeitungseinheit (6) so konfiguriert ist, dass sie Befehle zur Auslösung eines Alarms an den zweiten Detektor (20) und an den dritten Detektor (30) schickt.

5. Verfahren (S) zur Detektion eines Zielobjekts mit Hilfe eines Detektionssystems (1) nach einem der Ansprüche 1 bis 4, wobei das Detektionsverfahren (S) die folgenden Schritte umfasst:
S1: Erzeugen eines ersten Signals und eines zweiten Signals, die eine Stärke eines Magnetfelds anzeigen, durch den ersten und den zweiten Magnetsensor (5),
S2: Berechnen eines Werts auf der Basis des ersten und zweiten Signals, die von dem ersten und zweiten Magnetsensor (5) erzeugt wurden, durch die Verarbeitungseinheit (6), um einen berechneten Wert zu erhalten,
S4: Vergleichen des berechneten Werts mit einem vorgegebenen Schwellenwert, und
S5: wenn der berechnete Wert größer als der vorgegebene Schwellenwert ist, Verschicken von Befehlen zur Auslösung eines Alarms an den ersten Detektor (10) und/oder den zweiten Detektor (20) unter Verwendung der Kommunikationsschnittstelle (7).

6. Detektionsverfahren (S) nach Anspruch 5, wobei der erste Detektor die Verarbeitungseinheit (6) und eine Kommunikationsschnittstelle (7) umfasst und der zweite Detektor (20) eine Kommunikationsschnittstelle (7) umfasst, wobei das Verfahren ferner einen Schritt des Übertragens des von dem zweiten Magnetsensor (5) erzeugten zweiten Signals an die Verarbeitungseinheit (6) über die Kommunikationsschnittstellen (7) umfasst.

7. Verfahren nach einem der Ansprüche 5 oder 6, wobei der Verarbeitungsschritt (S2) einen der folgenden Teilschritte umfasst:
- Berechnen eines Mittelwerts der Signale aus dem ersten und zweiten Signal,
- Berechnen eines Mittelwerts der Signale aus dem ersten und zweiten Signal und Korrigieren (S3) des Mittelwerts durch Anwenden eines Dämpfungskoeffizienten auf den Mittelwert, um einen korrigierten Mittelwert zu erhalten,
- Korrigieren des erzeugten ersten und zweiten Signals durch Anwenden eines Dämpfungskoeffizienten auf die Signale, um korrigierte Werte zu erhalten, und Berechnen eines Mittelwerts aus den korrigierten Signalen,
- Korrigieren des ersten und zweiten Signals durch Anwenden eines Dämpfungskoeffizienten auf die Signale, um korrigierte Werte zu erhalten, und Berechnen einer Summe der korrigierten Werte,
- Korrigieren des ersten und zweiten Signals durch Anwenden eines Dämpfungskoeffizienten auf die Signale, um korrigierte Werte zu erhalten, und Ermitteln eines Maximalwerts der korrigierten Werte,
- Ermitteln einer Summe der Signale aus dem ersten und zweiten Signal und Korrigieren der Summe durch Anwenden eines Dämpfungskoeffizienten auf die Summe,
- Ermitteln eines Maximalwerts der Signale aus dem ersten und zweiten Signal und Korrigieren des Maximalwerts durch Anwenden eines Dämpfungskoeffizienten auf den Maximalwert.

8. Detektionsverfahren (S) nach Anspruch 7, wobei der Dämpfungskoeffizient gemäß den folgenden Teilschritten berechnet wird:
S31: Ermitteln eines Maximalwerts des ersten Signals und des zweiten Signals,
S32: Ermitteln eines Minimalwerts des ersten Signals und des zweiten Signals,
S32: Berechnen eines Verhältnisses zwischen dem so ermittelten Maximalwert und dem so ermittelten Minimalwert,
S34: Vergleichen des Verhältnisses mit einem ersten Schwellenwert und einem zweiten Schwellenwert, wobei der zweite Schwellenwert größer als der erste Schwellenwert ist, und
S35: Ableiten des Dämpfungskoeffizienten
- wobei der Dämpfungskoeffizient gleich ist:
- einem ersten Wert, wenn das Verhältnis kleiner als der erste Schwellenwert ist,
- einem zweiten Wert, der sich vom ersten Wert unterscheidet, wenn das Verhältnis größer als der zweite Schwellenwert ist, und
einem Wert zwischen dem ersten Wert und dem zweiten Wert, wenn das Verhältnis zwischen dem ersten Schwellenwert und dem zweiten Schwellenwert liegt, wobei der Dämpfungskoeffizient eine von dem Verhältnis abhängige lineare Funktion ist, wenn das Verhältnis zwischen dem ersten Schwellenwert und dem zweiten Schwellenwert liegt.

9. Detektionsverfahren (S) nach einem der Ansprüche 5 bis 8, wobei der erste Detektor (10) mindestens zwei erste Magnetsensoren (5) umfasst und der zweite Detektor (20) mindestens zwei zweite Magnetsensoren (5) umfasst, wobei jeder erste Magnetsensor (5) einem bestimmten zweiten Magnetsensor (5) zugeordnet ist, um ein Paar zu bilden, und wobei die Schritte S1 bis S4 auf jedes Paar angewendet werden.

10. Detektionsverfahren (S) nach einem der Ansprüche 5 bis 9, wobei das Detektionssystem (1) ferner einen dritten Detektor (30) umfasst, wobei der dritte Detektor (30) mindestens einen dritten Magnetsensor (5) umfasst, der so konfiguriert ist, dass er ein Magnetfeld erfasst und ein drittes Signal erzeugt, das eine Stärke des so erfassten Magnetfelds angibt, wobei das Detektionsverfahren (S) ferner umfasst:
vor dem Schritt S5 des Auslösens eines Alarms einen Verarbeitungsschritt des zweiten und dritten Signals, um einen verarbeiteten Wert zu erhalten; und
einen Schritt des Ableitens des oder der Ports, die einerseits von dem ersten Detektor (10) und den zweiten Detektor (20) und andererseits von dem zweiten Detektor (20) und den dritten Detektor (30) gebildet werden, der das Magnetfeld erfasst hat, aus dem verarbeiteten Wert des ersten und zweiten Signals sowie dem verarbeiteten Wert des zweiten und dritten Signals.

11. Detektionsverfahren (S) nach Anspruch 10, wobei der Schritt des Ableitens des oder der Ports die folgenden Teilschritte umfasst:
- Multiplizieren des aus dem zweiten und dritten Signal berechneten verarbeiteten Werts mit einem Sicherheitskoeffizienten (Ks),
- Vergleichen des aus dem ersten und zweiten Signal berechneten verarbeiteten Werts mit dem aus dem zweiten und dritten Signal berechneten verarbeiteten und mit dem Sicherheitskoeffizienten (Ks) multiplizierten Wert,
- Multiplizieren des aus dem ersten und zweiten Signal berechneten verarbeiteten Werts mit dem Sicherheitskoeffizienten (Ks),
- Vergleichen des aus dem zweiten und dritten Signal berechneten verarbeiteten Werts mit dem aus dem ersten und zweiten Signal berechneten verarbeiteten und mit dem Sicherheitskoeffizienten (Ks) multiplizierten Wert.

12. Detektionsverfahren (S) nach Anspruch 11, wobei:
- der Schritt S5 von dem ersten und zweiten Detektor (10, 20) nur dann ausgeführt wird, wenn der aus dem ersten und zweiten Signal berechnete verarbeitete Wert größer als der aus dem zweiten und dritten Signal berechnete verarbeitete und mit dem Sicherheitskoeffizienten (Ks) multiplizierte Wert ist, und
- der Schritt S5 von dem zweiten und dritten Detektor (20, 30) nur dann ausgeführt wird, wenn der aus dem zweiten und dritten Signal berechnete verarbeitete Wert größer als der aus dem ersten und zweiten Signal berechnete verarbeitete und mit dem Sicherheitskoeffizienten (Ks) multiplizierte Wert ist.

13. Verfahren nach einem der Ansprüche 10 bis 12, wobei der erste Detektor (10) und der zweite Detektor (20) jeweils eine Verarbeitungseinheit (6) umfassen, und wobei:
- der Schritt des Berechnens des verarbeiteten Werts des zweiten und dritten Signals von der Verarbeitungseinheit (6) des zweiten Detektors (20) durchgeführt wird,
- der Schritt des Berechnens des verarbeiteten Werts des ersten und zweiten Signals von der Verarbeitungseinheit (6) des ersten Detektors (10) durchgeführt wird, und
- der Schritt des Ableitens des oder der Detektorpaare (10, 20, 30), die das Magnetfeld erfasst haben, von der Verarbeitungseinheit (6) des zweiten Detektors (20) und von der Verarbeitungseinheit (6) des ersten Detektors (10) durchgeführt wird.

14. Detektionsverfahren (S) nach Anspruch 11, wobei das Detektionssystem (1) ferner einen vierten Detektor (n + 1) umfasst, wobei der vierte Detektor (n + 1) mindestens einen vierten Magnetsensor (5) umfasst, der so konfiguriert ist, dass er ein Magnetfeld erfasst und ein viertes Signal erzeugt, das eine Stärke des so erfassten Magnetfelds angibt, wobei das Detektionsverfahren (S) ferner die folgenden Teilschritte umfasst:
- Berechnen eines verarbeiteten Werts des dritten und vierten Signals,
- Multiplizieren des verarbeiteten Werts des dritten und vierten Signals mit dem Sicherheitskoeffizienten (Ks),
- Vergleichen des verarbeiteten Werts des zweiten und dritten Signals mit dem verarbeiteten, mit dem Sicherheitskoeffizienten (Ks) multiplizierten Wert des dritten und vierten Signals,
- Vergleichen des verarbeiteten Werts des dritten und vierten Signals mit dem verarbeiteten, mit dem Sicherheitskoeffizienten (Ks) multiplizierten Wert des zweiten und dritten Signals, und
- Ableiten des oder der Detektorpaare aus dem ersten, zweiten, dritten und vierten Detektor (10, 20, 30, n + 1), die das Magnetfeld erfasst haben.

15. Detektionsverfahren nach Anspruch 14, wobei:
- der Schritt S5 nur dann von dem zweiten und dem dritten Detektor (20, 30) ausgeführt wird, wenn der verarbeitete Wert des zweiten und dritten Signals größer als der verarbeitete, mit dem Sicherheitskoeffizienten (Ks) multiplizierte Wert des dritten und vierten Signals ist, und
- der Schritt S5 nur dann von dem dritten und vierten Detektor (10, 20) ausgeführt wird, wenn der verarbeitete Wert des dritten und vierten Signals größer als der verarbeitete, mit dem Sicherheitskoeffizienten (Ks) multiplizierte Wert des zweiten und dritten Signals ist.

## Claims

1. A detection system (1) of a target object comprising:
- a first detector (10) comprising at least one first magnetic sensor (5) configured to generate a first signal indicative of an intensity of of a detected magnetic field and at least one transmitter (8),
- a second detector (20) distinct from the first detector (10) and comprising at least one second magnetic sensor (5) configured to generate a second signal indicative of an intensity of a detected magnetic field and at least one transmitter (8),
- either a processing unit (6) configured to receive the first signal generated by the first magnetic sensor (5) and the second signal generated by the second magnetic sensor (5), or a processing unit (6) configured to receive the first signal generated by the first magnetic sensor (5) and a processing unit (6) configured to receive the second signal generated by the second magnetic sensor (6),
- a communication interface (7), said interface being configured to transmit the first and second signals to the processing unit (6), at least one of the processing units (6) being configured to send alarm-generation instructions to the transmitter (8) of the first detector (10) and/or the second detector (20),
the detection system (1) being **characterized in that** the communication interface (7) is configured to transmit the second signal to the processing unit (6) receiving the first signal, said processing unit (6) being configured to calculate a value based on each of the first and second signals, to compare the calculated value to a predetermined threshold value and, when said calculated value exceeds the predetermined threshold value, to send instructions to generate an alarm to the transmitter (8) of the first detector (10) and/or the second detector (20).

2. A detection system (1) according to claim 1, wherein the calculated value comprises an average value of the first signal and the second signal and/or a value corrected by applying an attenuation coefficient to the first and second signals.

3. A detection system (1) according to one of claims 1 and 2, wherein the first and second detectors (10, 20) are portable and the communication interface (7) is wireless.

4. A detection system (1) according to any one of claims 1 to 3, further comprising a third detector (30) and in which:
- the third detector (30) comprises at least one third magnetic sensor (5) configured to detect a magnetic field and generate a third signal indicative of an intensity of the magnetic field thus detected,
- the first detector (10) and the second detector (20) form a first gate, and the second detector (20) and the third detector (30) together form a second gate,
- a processing unit (6) is housed in each of the first and second detectors (10, 20), and
- the processing unit (6) housed in the second detector (20) is configured to send alarm-generation instructions to the second detector (20) and the third detector (30).

5. A method (S) for detecting a target object using a detection system (1) according to any one of claims 1 to 4, said detection method (S) comprising the following steps:
S1: generation, by the first and the second magnetic sensors (5), of a signal representative of an intensity of a magnetic field,
S2: calculation, by the processing unit (6), of a value based on each of the first and second signals generated by the first and second magnetic sensors (5) so as to obtain a calculated value,
S4: comparison of the calculated value to a predetermined threshold value, and
S5: when the calculated value is greater than the predetermined threshold value, sending of instructions to generate an alarm to the first detector (10) and/or the second detector (20) using the communication interface (7).

6. A detection method (S) according to claim 5, wherein the first detector comprises the processing unit (6) and a communication interface (7), and the second detector (20) comprises a communication interface (7), the method further comprising a step of transmitting the second signal generated by the second magnetic sensor (5) to the processing unit (6) via the communication interfaces (7).

7. A method according to one of claims 5 or 6, wherein the calculation step (S2) comprises one of the following substeps:
- calculation, based on the first and second signals, of an average value of said signals,
- calculation, from the first and second signals, of an average value of said signals and correction (S3) of the average value so as to obtain a corrected average value by applying an attenuation coefficient to the average value,
- correction of the generated first and second signals to obtain corrected values by applying an attenuation coefficient to said signals, and calculation of an average value from the corrected signals,
- correction of the first and second signals to obtain corrected values by applying an attenuation coefficient to said signals, and calculation of a sum of said corrected values,
- correction of the first and second signals to obtain corrected values by applying an attenuation coefficient to said signals, and determination of a maximum value of said corrected values,
- determination, from the first and second signals, of a sum of the signals and correcting said sum by applying an attenuation coefficient to said sum,
- determination, from the first and second signals, of a maximum value of the signals and correcting said maximum value by applying an attenuation coefficient to said maximum value.

8. A detection method (S) according to claim 7, in which the attenuation coefficient is calculated in accordance with the following substeps:
S31: determination of a maximum value of the first signal and the second signal,
S32: determination of a minimum value of the first signal and the second signal,
S32: calculation of a ratio between the maximum value and the minimum value thus determined,
S34: comparison of the ratio to a first threshold and a second threshold, the second threshold being greater than the first threshold, and
S35: deduction of the attenuation coefficient
- where the attenuation coefficient is equal to:
- a first value when the ratio is less than the first threshold,
- a second value different from the first value when the ratio is greater than the second threshold, and
a value between the first value and the second value when the ratio is between the first threshold and the second threshold, the attenuation coefficient being a linear function of the ratio when said ratio is between the first threshold and the second threshold.

9. A detection method (S) according to any one of claims 5 through 8, wherein the first detector (10) comprises at least two first magnetic sensors (5) and the second detector (20) comprises at least two second magnetic sensors (5), each first magnetic sensor (5) being associated with a given second magnetic sensor (5) so as to form a pair, and wherein steps S1 through S4 are applied to each pair.

10. A detection method (S) according to any one of claims 5 through 9, wherein the detection system (1) further comprises a third detector (30), said third detector (30) comprising at least one third magnetic sensor (5) configured to detect a magnetic field and generate a third signal indicative of an intensity of the magnetic field thus detected, the detection method (S) further comprising:
prior to step S5 of generation of an alarm, a step of processing the second and third signals to obtain a processed value; and
a step of deducing, based on the processed value of the first and second signals and the processed value of the second and third signals, the gate(s) formed by the first detector (10) and the second detector (20), on the one hand, and the second detector (20) and the third detector (30), on the other hand, that have detected the magnetic field.

11. A detection method (S) according to claim 10, wherein the step of determining the gate(s) comprises the following substeps:
- multiplication of the processed value calculated from the second and third signals by a safety factor (Ks),
- comparison of the processed value calculated from the first and second signals to the processed value calculated from the second and third signals and multiplied by the safety factor (Ks),
- multiplication of the processed value calculated from the first and second signals by the safety factor (Ks),
- comparison of the processed value calculated from the second and third signals to the processed value calculated from the first and second signals and multiplied by the safety factor (Ks).

12. A detection method (S) according to claim 11, wherein:
- step S5 is performed by the first and second detectors (10, 20) only if the processed value calculated from the first and second signals is greater than the processed value calculated from the second and third signals multiplied by the safety factor (Ks), and
- step S5 is performed by the second and third detectors (20, 30) only if the processed value calculated from the second and third signals is greater than the processed value calculated from the first and second signals and multiplied by the safety factor (Ks).

13. A method according to any one of claims 10 through 12, wherein the first detector (10) and the second detector (20) each comprise a processing unit (6), and wherein:
- the step of calculation of the processed value of the second and third signals is performed by the processing unit (6) of the second detector (20),
- the step of calculation of the processed value of the first and second signals is performed by the processing unit (6) of the first detector (10), and
- the step of determination of the pair or pairs of sensors (10, 20, 30) that detected the magnetic field is performed by the processing unit (6) of the second sensor (20) and by the processing unit (6) of the first sensor (10).

14. A detection method (S) according to claim 11, wherein the detection system (1) further comprises a fourth detector (n + 1), said fourth detector (n + 1) comprising at least a fourth magnetic sensor (5) configured to detect a magnetic field and generate a fourth signal indicative of an intensity of the magnetic field thus detected, the detection method (S) further comprising the following substeps:
- calculation of a processed value of the third and fourth signals,
- multiplication of the processed value of the third and fourth signals by the safety factor (Ks),
- comparison of the processed value of the second and third signals to the processed value of the third and fourth signals multiplied by the safety factor (Ks),
- comparison of the processed value of the third and fourth signals to the processed value of the second and third signals multiplied by the safety factor (Ks); and
- determination of the pair or pairs of sensors from among the first, second, third, and fourth sensors (10, 20, 30, n + 1) that detected the magnetic field.

15. A detection method according to claim 14, wherein:
- step S5 is performed by the second and third detectors (20, 30) only if the processed value of the second and third signals is greater than the processed value of the third and fourth signals multiplied by the safety factor (Ks), and
- step S5 is performed by the third and fourth detectors (10, 20) only if the processed value of the third and fourth signals is greater than the processed value of the second and third signals multiplied by the safety factor (Ks).
